# EUROPÄISCHE PATENTSCHRIFT

(11) **EP 4 200 153 B1**
(45) Veröffentlichungstag und Bekanntmachung des Hinweises auf die Patenterteilung: **01.05.2024**
(21) Anmeldenummer: 21763086.2
(22) Anmeldetag: 19.08.2021
(51) Int. Cl.: B60L 3/12, B60L 53/62, B60L 53/10, B60L 53/14, B60L 53/66, B60L 53/68, B60L 53/65, G01R 31/371, G01R 31/367, H02J 7/02, H01M 10/42

(54) **ELEKTROMOBILITÄT-LADETESTSYSTEM UND ELEKTROMOBILITÄTS-LADETESTVERFAHREN**
ELECTROMOBILITY CHARGING SYSTEM AND ELECTROMOBILITY CHARGING TESTING METHOD
ELECTROMOBILITÉ SYSTÈME DE CHARGE ET ELECTROMOBILITÉ PROCÉDÉ DE TEST DE CHARGE

(30) Priorität: 21.08.2020 DE 102020121988
(43) Veröffentlichungstag der Anmeldung: 28.06.2023
(73) Patentinhaber: comemso Immobilien GmbH & Co. KG, 73760 Ostfildern (DE)
(72) Erfinder: ATHANASAS, Kiriakos, 73760 Ostfildern (DE); ATHANASAS, Anita, 73760 Ostfildern (DE)
(74) Vertreter: Spachmann, Holger
(86) Internationale Anmeldenummer: PCT/EP2021/073032
(87) Internationale Veröffentlichungsnummer: WO 2022/038225

(56) Entgegenhaltungen:
- EP-A1- 2 498 363
- WO-A1-2014/169927
- WO-A2-03/081538
- US-A1- 2006 089 733
- US-A1- 2014 225 620

## Beschreibung

Die vorliegende Erfindung betrifft ein Elektromobilitäts-Ladetestsystem zum Generieren und Austausch von Messdaten und / oder Lademodelle von elektrischen Verhaltensweisen, insbesondere Spannungs- und / oder Stromverhalten, Protokollparametern und Kommunikationsinhalten eines Ladevorgangs eines Elektrofahrzeugs und / oder einer Ladestation sowie zum Prüfen der Kommunikationsfähigkeit des Elektrofahrzeugs und / oder der Ladestation. Die Erfindung betrifft ferner ein Elektromobilitäts-Ladetestverfahren.

### STAND DER TECHNIK

Im Bereich der Elektromobilität gibt es sehr viele Ladestationen-Hersteller und Elektrofahrzeughersteller weltweit, für welche es aufgrund einer Vielzahl von Varianten und Versionen nicht möglich ist, eine 100%-Interoperabilitätserprobung miteinander regelmäßig durchzuführen. Mit der Interoperabilität wird eine Fähigkeit unterschiedlicher Systeme zum möglichst nahtlosen Zusammenarbeiten dargestellt.

Bekannt sind elektrische Aufzeichnungsvorrichtungen bzw. Prüfungsvorrichtungen, mit denen ein spezifisches Elektrofahrzeug oder eine spezifische Ladestation nach Norm geprüft werden kann, oder um eine spezifische Ladestation oder ein Elektrofahrzeug bzgl. einer Interoperabilität zwischen diesen spezifischen Komponenten zu prüfen. Die Aufzeichnungsvorrichtung kann ferner dafür verwendet werden, zwischen einer Ladestation und einem Elektrofahrzeug zu messen, zu analysieren und aufzuzeichnen. Die mittels der Aufzeichnungsvorrichtung erfassten Daten können in einer Datenbank gespeichert und von einem Anwender verwaltet werden. Der Anwender kann mittels der Daten einige elektrische Verhaltensweisen zwischen dem Elektrofahrzeug und der Ladestation simulativ nachbilden oder an einem Labor-Prüfplatz mit einer simulierten Ladestation einen Ladeprozess eines Elektrofahrzeugs abprüfen oder ein Elektrofahrzeug nachstellen, um eine spezifische Ladestation mit dieser elektrischen Verhaltensweise abzuprüfen.

Ein derartiges gattungsgemäßes System und Verfahren zum Modellieren oder Simulieren einer Anwendungsumgebung, um das Verhalten einer bestimmten Batterie und eines Ladegeräts innerhalb des Elektrofahrzeugs in der Anwendungsumgebung zu analysieren, ist beispielsweise in der WO 2004/073088 A2 beschrieben. Ein Analysegerät kann zum Empfangen von Daten verwendet werden, die von einer Datenaufzeichnungseinheit während eines realen Ladevorgangs erfasst werden. Das Analysegerät kann die Daten analysieren, um ein Energieübertragungsprofil festzulegen. Weiterhin können die Daten in einem Cloudspeicher im Internet hochgeladen und von anderen Anwendern heruntergeladen werden, um den konkreten Ladevorgang analysieren zu können.

Die DE 10 2014 205 924 A1 offenbart eine Speichereinheit für eine Fahrzeugdatenaufzeichnung. In der Speichereinheit ist ein Batteriesteuergerät mit einer Software vorgesehen. Die Software ermöglicht eine Erfassung und Analyse von Messdaten, wobei es sich bei den Messdaten um batterierelevante Daten, Fahrzeugdaten, Traktionsbatteriedaten oder Umweltdaten handeln kann. Diese Messdaten werden während eines Fahrzyklus eines Elektrofahrzeugs aufgezeichnet. Durch ein mobiles Endgerät können die Fahrzyklus-Messdaten über ein Internet-Interface auf einen Internetserver hochgeladen werden, so dass diese Daten in Datenbanken eingeschrieben und für Fahrzeughersteller oder Batterielieferanten zur Verfügung gestellt werden können.

In der DE 10 2015 114 527 A1 ist ein Testsystem einer Gleichstrom-Schnellladung für Elektrofahrzeuge beschrieben. Das Testsystem umfasst einen Gleichstromschnellade-Tester und kann eine Simulation eines Ladeprozesses durchführen. Damit kann eine Diagnose eines fehlgeschlagenen Ladeereignisses des Elektrofahrzeugs durchgeführt werden.

Weiterhin ist durch die DE 20 2012 100 613 U1 ein Prüferstecker für Ladestationen von Elektrofahrzeugen bekannt. Der Prüferstecker umfasst ein Steuerungsmodul zum Simulieren von Funktion des an die Ladestation angeschlossenen Elektrofahrzeugs.

Die DE 10 2017 214 071 A1 beschreibt ein Verfahren zum Laden eines Elektrofahrzeugs, wobei über ein übergeordnetes Rechenzentrum eine Ladesteuerung einer Ladestation und des Elektrofahrzeugs durchgeführt wird.

In der US 2015/0346288 A1 ist eine Vorrichtung zum Testen von einer Ladestation für ein Elektrofahrzeug, insbesondere zum Messen der von der Ladestation dem Elektrofahrzeug gelieferten Energie beschrieben. Die Vorrichtung kann in einem aktiven oder einem passiven Modus, das Testen durchführen. Im passiven Modus ist ein reales Elektrofahrzeug an die Ladestation angeschlossen. Interaktionen zwischen dem Elektrofahrzeug und der Ladestation sind durch die Vorrichtung überwacht und Parameter können gemessen werden. Im aktiven Modus sind eine Last und Protokolle mit der Vorrichtung zum Emulieren einer vom zu prüfenden Elektrofahrzeug bereitgestellten Last verbunden, wobei die Last als eine programmierbare Last ausgebildet sein kann. Die Last kann als ohmsche Last oder elektronische Last entweder in der Vorrichtung integriert oder an dieser anbringbar sein. Ausgehend von der US 2015/0346288 A1 ist die Last eine insbesondere durch Programmieren vor dem Testen bereits vorkonfigurierte Last, die ausgelegt ist, das Elektrofahrzeug zu emulieren. Während einem Testprozess werden lediglich die Messungen durchgeführt und die zu messenden Daten durch die Vorrichtung aufgezeichnet.

Weiterhin ist ein Elektrofahrzeug-Ladestation-Testsystem in der US 2013/0346025 A1 dargestellt, wobei das Testsystem ein Lastmodul umfasst. Das Lastmodul kann eine Last eines Elektrofahrzeugs emulieren. Das Lastmodul ist mit einer variablen Last ausgestattet, wobei durch Steuerung ein Widerstand und andere Lasteigenschaften des Lastmoduls kontrolliert werden können. Dadurch können ein Elektrofahrzeug-Batteriesystem und anderes unerwartetes Verhalten wie etwa fehlerhafte Elektrofahrzeug-Batterie emuliert werden. Das Testsystem ist ebenfalls ein reines Aufzeichnungs- und Messungssystem, wobei ein vor dem Testen vorkonfiguriertes Lastmodul zum Emulieren des Elektrofahrzeug-Batteriesystems angeordnet ist.

In der US 2012/0116745 A1 ist eine Vorrichtung, die zum Simulieren und Testen einer Ladestation für Elektrofahrzeuge dient. Die Vorrichtung ist mit Widerstandslasten zum Simulieren der Lasten der Elektrofahrzeuge ausgestattet.

Weiterhin stellt der Artikel "Konzept und Prototyp zur Überprüfung der Schutzmaßnahmen gegen elektrischen Schlag von DC-Ladestationen für Elektrofahrzeuge" von Herbst, D., Schmautzer, E., Schürhuber, R., Jauk, B., Unterweger, M., & Wolf, C., 15. Symposium Energieinnovation, Graz, Austria, Conference vom 14.02.2018, Through 16.12.2018, DOI 10.3217/978-3-85125-586-7, ein Prüfgerät zur Überprüfung von Schutzmaßnahmen gegen elektrischen Schlag von DC-Ladestationen für Elektrofahrzeuge dar, wobei das Prüfgerät eine elektronische Last zum Simulieren eines Akkumulators des Elektrofahrzeugs und einer damit verbundenen Kommunikation umfasst.

Des Weiteren ist im Artikel "Power hardware-in-the-loop test bench for tests and verification of EV and EVSE charging systems" von A. Popov, M. Tybel and M. Schugt, 2014 IEEE International Electric Vehicle Conference (IEVC), 2014, pp. 1-8. Doi: 10.1109/IEVC.2014.7056139, ebenfalls eine allgemeine Prüfvorrichtung für Elektrofahrzeuge und Ladestationen gezeigt. Durch die Vorrichtung können Elektrofahrzeuge emuliert werden.

Das Dokument "NATIONAL ELECTRIC TRANSPORTATION INFRASTRUCTURE WORKING COUNCIL" vom Theodore Bohn, EVSE Testing Tool Options In: EPRI IWC Meeting, Day Two Presentations, Electric Power Research Institute, Inc, October 26, 2017, Seite 2-20, https://www.epri.com/pages/sa/infrastructure-working.council [download am 27.04.2021], beschreibt eine Prüfvorrichtung zum Testen von Ladestationen, wobei diese Vorrichtung mit einem Elektrofahrzeug-Emulator konfiguriert ist. Mit der Prüfvorrichtung kann ermöglicht werden, ohne gegenständliche Elektrofahrzeuge die Ladestation zu testen. Wie genau diese Prüfvorrichtung ausgebildet ist und funktioniert, ist aus dem Dokument nicht deutlich entnehmbar.

WO 03/081538 A2 , EP 2 498 363 A1, US 2006/089733 A1 offenbaren Elektromobilitäts-Ladesysteme und Ladetestsysteme zum Generieren und Austausch von Messdaten oder eines Lademodells von elektrischen Verhaltensweisen, eines Ladevorgangs eines Elektrofahrzeugs, sowie zum Prüfen der Kommunikationsfähigkeit und/oder der Ladefähigkeit des Elektrofahrzeugs. H

Bei den bekannten Aufzeichnungs- bzw. Prüfvorrichtungen ergibt sich das Problem, dass jeder Elektrofahrzeughersteller oder Ladestationshersteller spezifische Ladevorgänge von individuellen Elektrofahrzeugen oder Ladestationen mittels einer speziellen Aufzeichnungs- bzw. Prüfvorrichtung aufzeichnet, wobei aber eine möglichst vollständige Messungsdatensatz verschiedener Elektrofahrzeuge für den Ladestationshersteller oder verschiedener Ladestationen für den Elektrofahrzeughersteller nötig ist. Die aufgezeichneten Messdaten können nicht automatisiert zum Wiederabspielen verwendet werden. Die Messdaten müssen manuell extrahiert und bei einer Emulation manuell vorkonfiguriert werden, um automatisierte Nachbildungen der Ladestationen oder Elektrofahrzeuge durchzuführen. Da sich der Markt schnell ändert, müssen die Elektrofahrzeughersteller mit einer hohen Vielzahl der Ladestationen und die Ladestationshersteller mit einer hohen Vielzahl der Elektrofahrzeuge geprüft werden, um die Interoperabilität sicher gewährleisten und somit Marktveränderungen folgen zu können.

Ausgehend von dem obigen Stand der Technik ist es Aufgabe der Erfindung, ein Elektromobilitäts-Ladetestsystem und ein entsprechendes Elektromobilitäts-Ladetestverfahren vorzuschlagen, mit welchem Messdaten und / oder Lademodelle von elektrischen Verhaltensweisen einer Vielzahl verschiedener Ladesäulentypen oder Elektrofahrzeugtypen generiert und ausgetauscht und damit die Kommunikationsfähigkeit bzw. Interoperabilität eines konkreten Typs eines Elektrofahrzeugs und / oder der Ladestation geprüft werden können.

Die Aufgabe wird durch ein Elektromobilitäts-Ladetestsystem mit den Merkmalen des Anspruchs 1 und durch ein Elektromobilitäts-Ladetestverfahren mit den Merkmalen des nebengeordneten Verfahrensanspruchs gelöst. Vorteilhafte Weiterbildungen der Erfindung sind Gegenstände der Unteransprüche.

### OFFENBARUNG DER ERFINDUNG

Die Erfindung ist in den anhängenden Ansprüchen definiert.

Durch das erfindungsgemäße Elektromobilitäts-Ladetestsystem wird ermöglicht, dass der Ladevorgang des Elektrofahrzeugs und / oder der Ladestation von der Messvorrichtung gemessen und aufgezeichnet wird, so dass die elektrischen Verhaltensweisen, insbesondere Spannungs- und / oder Stromverhalten während des Ladevorgangs, die Protokollparameter und die Kommunikationsinhalte des Ladevorgangs, insbesondere Signalwerte und Signalqualität, bereitgestellt sind. Durch die Messvorrichtung ist es weiterhin möglich, ein vielfältiges Verhalten zwischen dem Elektrofahrzeug und der Ladestation zu messen. Basierend auf den Messdaten wird der Ladevorgang des Elektrofahrzeugs und / oder der Ladestation von der Modellierungsvorrichtung emuliert. Die Lademodelle können dabei automatisiert, halb-automatisiert oder manuell aus den Messdaten generiert werden, wobei ein Test des Ladeverhaltens auf Basis von Lademodellen als reaktive Modellierung bezeichnet werden kann, dass auf einem Datenbankbasierten Modell von Aktion und Reaktion basiert. Lademodelle können bei unvollständigen Messdaten um manuell generierten Daten ergänzt werden um ein vollständiges Lademodell zu erhalten, wobei es eine Möglichkeit geben soll reale Messdaten und manuell generierte Daten zu unterscheiden und zu kennzeichnen. Basierend auf den aufgezeichneten Messdaten können Lademodelle von Ladevorgängen sowohl elektrofahrzeugseitig als auch ladestationsseitig automatisiert generiert werden.

Daneben werden die Messdaten in Aktions- und Reaktionsdaten aufgeteilt und damit können entsprechende Lademodelle für Aktion und Reaktion automatisiert generiert werden. Dies dient zu einer realitätsnäheren Abbildung des Lademodells, da das Laden zwischen dem Elektrofahrzeug und der Ladestation aus der Aktion und Reaktion besteht. Sobald das Elektrofahrzeug an die Ladestation angeschlossen ist, können die Aktionsdaten gemäß der Aktion des zu prüfenden Elektrofahrzeugs geprüft werden. Dadurch wird festgelegt, ob eine gleiche oder ähnliche Aktion durchgeführt werden kann. Die an die Aktion anpassenden Reaktionsdaten können somit ausgewählt und die entsprechenden Reaktionen der Ladestation für das zu prüfenden Fahrzeug abgespielt werden, um die Ladestation als Lademodell nachzubilden. Dadurch wird eine möglichst realitätsnahe Nachahmung eines Ladevorgangs sowohl von Seiten des Elektrofahrzeugs als auch der Ladestation ermöglicht. Das emulierte Elektrofahrzeug und Ladestation erhalten die gleichen Daten- und Energiezuflüsse und führen vergleichbare Vorgänge aus und erzielen ein möglichst gleiches Ergebnis, wie reale Elektrofahrzeuge und Ladestationen in derselben Ladesituationen.

Mit dem erfindungsgemäßen Elektromobilitäts-Ladetestsystem wird ermöglicht, dass die Kommunikation zwischen den Elektrofahrzeugen und den Ladestationen reproduziert und jederzeit erneut getestet werden kann, um einen kompatiblen Softwarestand zu erreichen.

Durch die Erfindung kann in verschiedenen Abstufungen eine Interoperabilitätsprüfungen zwischen Elektrofahrzeugen und Ladestationen ganz oder teilweise durch Emulationen ersetzt werden und über die hier dargestellten Mechanismen realitätsnah von Aktionen und Reaktionen nachgebildet werden. Mit dem Austausch der Messdaten und / oder Lademodellen über eine Servervorrichtung oder eine Datenbank, und einer Anbindung an einen cloudbasierten Internetserver mit Online-Austauschplattform soll der Austausch zwischen vielen Anwendern möglich sein und über die Gewinnung vieler Messdaten und / oder Generierung vieler Lademodelle durch eine hohe Anzahl an Nutzern kann die Emulationsgenauigkeit weiter verfeinert werden.

Gemäß der Erfindung können die Messdaten und / oder Lademodelle auf die Servervorrichtung hochgeladen werden, so dass eine universelle, typenübergreifende Datenbank aufgebaut und eine Möglichkeit zum flexiblen Austausch und Ergänzung der Messdaten und / oder Lademodelle geboten werden kann. Es wird weiterhin mit der Datenbank ermöglicht, eine hohe Abdeckung der Typenvielfalt der Elektrofahrzeuge und Ladestationen zu erreichen. Die Servervorrichtung, die im engeren Sinn eine Datenbank ist, kann als geräteinterne Servervorrichtung, d.h. Datenspeicher oder auch als externer, insbesondere internetbasierter Cloudserver bzw. als eine cloudbasierte Servervorrichtung ausgebildet sein, und kann auch eine Mischform einer internen Datenbank und eines externen Datenservers sein.

Die Messdaten und / oder die Lademodelle können von anderen Anwendern durch die Emulationsvorrichtung von der Servervorrichtung heruntergeladen werden. Werden die Messdaten heruntergeladen, können Lademodelle auf eine lokale Modellierungsvorrichtung generiert werden. Werden die Lademodelle heruntergeladen, können diese Daten auf einem elektronischen Gerät unmittelbar abgespielt werden, so dass ein Ladevorgang bzw. Funktionen des / der zuvor gemessenen und / oder durch ein Lademodell nachgebildetes Elektrofahrzeugs oder einer Ladestation teilweise oder vollständig emuliert werden. Es ist vorteilhaft, mittels der Emulationsvorrichtung die Messdaten und / oder Lademodelle unmittelbar von der Messvorrichtung und / oder der Modellierungsvorrichtung herunterzuladen. In dem Kontext der Erfindung wird unter Emulation insbesondere eine möglichst realitätsnahe Nachahmung des Ladevorgangs von Seiten des Elektrofahrzeugs bzw. der Ladesäule als nachzuahmende Entität betrachtet. Dabei bildet die Emulation die Ladesäule bzw. das Elektrofahrzeug die Aktionen und Reaktion eines Ladevorgangs zumindest in bestimmten Teilaspekten nach. Das emulierte Elektrofahrzeug / Ladesäule erhält die gleichen Daten- und Energiezuflüsse führt vergleichbare Vorgänge aus und erzielt die möglichst gleichen Ergebnisse bzw. gibt dieselbe Energiemengen und Daten aus wie eine reales Elektrofahrzeug / Ladesäule in derselben Ladesituation.

Vorteilhafterweise können Metadaten auf die Servervorrichtung hochgeladen werden. Die Metadaten umfassen zusätzliche Informationen des Elektrofahrzeugs und / oder der Ladestation oder Informationen des Messvorgangs zwischen der Ladestation und dem Elektrofahrzeug, wie z.B. Gerätehersteller, Gerätetyp, Gerätemodell, Herstellungsdatum, Seriennummer, Softwareversion, Aufzeichnungsdatum, Fotos von Geräten, Fotos von Typenschildern, Standort von Geräten, Batteriekapazität, Batterie-Innenwiderstand und weitere Batteriedaten. Die Metadaten können weiterhin Informationen der Messvorrichtung und / oder Modellierungsvorrichtung beispielsweise Firmware-Version, Gerätehersteller, Gerätetyp, Hardwareversion, Software-Umfang umfassen. Sowohl die Messdaten als auch die Modelle können über die Servervorrichtung, insbesondere durch Anbindung an den cloudbasierten Internetserver, zwischen vielen Anwendern ausgetauscht werden. Weiterhin kann durch Hochladen der Messdaten und Modelle eine universelle typenübergreifende Datenbank aufgebaut und eine Möglichkeit zum flexiblen Austausch und zur Ergänzung der Messdaten und / oder Lademodelle geboten werden. Dabei wird ermöglicht, dass eine hohe Abdeckung der Typenvielfalt der Elektrofahrzeuge und Ladestationen erreicht werden kann. Mit dem erfindungsgemäßen Elektromobilitäts-Ladetestsystem wird einem Ladestationshersteller vorteilhaft ermöglicht, durch Lademodelle und / oder Messdaten der Elektrofahrzeuge auch ohne gegenständliches Elektrofahrzeug sein Produkt mit spezifischen Elektrofahrzeug-Eigenschaften, die dem Ladestationshersteller nicht zur Verfügung stehen, auf Interoperabilität zu prüfen. Für Elektrofahrzeughersteller können die Interoperabilität der Elektrofahrzeuge mittels der Lademodelle und / oder Messdaten der Ladestationen ohne gegenständliche Ladestation geprüft werden.

Es ist weiterhin vorteilhaft, die Messdaten und / oder Lademodelle durch das Elektromobilitäts-Ladetestsystem weltweit auszutauschen. Dadurch können Kosten und Zeit gespart und es kann ein ansprechendes Elektromobilitäts-Ladetestsystem bei hoher Flexibilität erreicht werden. Der Austausch kann durch eine Beschränkung, beispielsweise eine finanzielle Transaktionsbarriere, eine Registrierungs- oder Zertifizierungsbarriere oder ähnliches eingeschränkt sein.

Somit wird gemäß der Erfindung ein Elektromobilitäts-Ladetestsystem bei hoher Flexibilität erreicht. Mit dem erfindungsgemäßen Elektromobilitäts-Ladetestsystem können Kosten und Zeit gespart werden.

In einer vorteilhaften Weiterbildung des Elektromobilitäts-Ladetestsystems kann die Messvorrichtung eine Schnittstelleneinrichtung zur Verbindung an ein Elektrofahrzeug und / oder eine Ladestation, eine Aufzeichnungseinrichtung und eine Netzwerkverbindungseinrichtung umfassen, wobei die Messdaten über die Schnittstelleneinrichtung mittels der Aufzeichnungseinrichtung protokollierbar sind, und durch die Netzwerkverbindungseinrichtung auf die Servervorrichtung hochladbar und / oder zur Modellierungsvorrichtung übertragbar sind. Die Netzwerkverbindungseinrichtung dient somit als Datenschnittstelle einer systeminternen Kommunikation zwischen den einzelnen Vorrichtungen des Systems, wobei diese lokal, aber auch über das Internet erfolgen kann. Die Messvorrichtung kann mit der Ladestation oder mit dem Elektrofahrzeug über die Schnittstelleneinrichtung elektrisch verbunden sein und kann Strom- und Spannungssensoren, aber auch Buskoppler bzw. Datenaufnahmesensoren einer Kommunikationsverbindung zwischen Elektrofahrzeug und Ladesäule zur Messung umfassen. Weiterhin kann die Schnittstelleneinrichtung Aktoren zur Einkopplung von Strom- und Spannungswerten, aber auch Dateninhalte in die Kommunikationsverbindung umfassen. Somit kann die Messvorrichtung als Systeminterfache zwischen der Ladestation und dem Elektrofahrzeug zum Protokollieren ihres elektrischen Verhaltens wie Strom- und Spannungsverläufe sowie übermittelter analoger und/oder digitaler Daten und Informationsinhalte gemäß eines Kommunikationsstandards während eines Ladevorgangs eingesetzt werden, sowie weiterer Messwerte wie Temperatur- oder Widerstandswerte aus der Schnittstelleneinrichtung. Die Messvorrichtung kann aber auch direkt an ein Elektrofahrzeug oder eine Ladesäule zur Emulation des Verhaltens eines Gegenparts durch Empfang und Vorgabe entsprechender Kommunikationsinhalte und Strom- und Spannungswerte eingesetzt werden. Dabei ist die Messvorrichtung über die Schnittstelleneinrichtungen bzw. Systeminterface an die Ladestation und das Elektrofahrzeug angeschlossen.

In einer weiteren vorteilhaften Weiterbildung kann die Netzwerkverbindungseinrichtung als eine kabelgebundene Datenschnittstelle, insbesondere eine CAN-Schnittstelle, Ethernet (inkl. aller echtzeit- und nichtechtzeitfähige Ausprägungen), LIN, RS232, GPIB, SPI, I2C, MOST-Bus, FlexRay, Profibus, CANopen, SERCOS, ausgeführt sein. Alternativ oder zusätzlich kann diese als eine drahtlose Netzwerkverbindungseinrichtung, insbesondere eine Mobilfunk-, WLAN- oder Bluetooth - Netzwerkverbindungseinrichtung, im Sinne einer Drahtlos-Datenschnittstelle ausgebildet sein, so dass die Messdaten über die Netzwerkverbindungseinrichtung innerhalb des Elektromobilitäts-Ladetestsystems (10) und/oder auf die Servervorrichtung und / oder zur Modellierungsvorrichtung übertragbar sind. Damit können die protokollierten Messdaten über die NFC-Netzwerkverbindungseinrichtung flexible und schnell auf die Servervorrichtung übertragen werden, wobei ggf. Servervorrichtung und Netzwerkverbindungseinrichtung nur bedarfsweise gekoppelt werden können, und somit Einzelgeräte kostengünstiger hergestellt werden können.

In einer weiteren vorteilhaften Weiterbildung können in der Modellierungsvorrichtung zumindest eine Netzwerkverbindungseinrichtung, bevorzugt eine drahtgebundene, insbesondere mit einer CAN-Schnittstelle, Ethernet (inkl. aller echtzeit- und nichtechtzeitfähigen Ausprägungen), LIN, RS232, GPIB, SPI, I2C, MOST-Bus, FlexRay, Profibus, CANopen, SERCOS ausgeführte Netzwerkverbindungseinrichtung, oder eine drahtlose Netzwerkverbindungseinrichtung, insbesondere eine Funk-, WLAN- oder Bluetooth-Netzwerkverbindungseinrichtung, zum Auslesen der Messdaten aus der Messvorrichtung und / oder aus der Servervorrichtung umfassen. Des Weiteren kann zumindest eine Modellierungseinrichtung zur Erstellung der Lademodelle des Ladevorgangs, insbesondere zwei Modellierungseinrichtungen für die Modellierung eines Lademodells des Elektrofahrzeugs und der Ladestation, zumindest eine Aufbereitungseinrichtung zur Verarbeitung der Messdaten zu einem an das Lademodell angepassten Datenformat und zumindest eine Netzwerkverbindungseinrichtung zum Hochladen des Lademodells auf die Servervorrichtung und / oder Herunterladen von Messdaten aus der Servervorrichtung und / oder zur Übermittlung zur Emulationsvorrichtung umfasst sein. Die Messdaten können zunächst über die Netzwerkverbindungseinrichtung der Modellierungsvorrichtung aus der Messvorrichtung und / oder der Servervorrichtung ausgelesen werden. Vor der Erstellung eines Lademodells kann das Datenformat der Messdaten durch die Aufbereitungseinrichtung an das Lademodell angepasst werden. Anschließend kann Generieren des Lademodells basierend auf den Messdaten mit dem angepassten Datenformat durch die Modellierungseinrichtung durchgeführt werden, wobei ein oder mehrere Modelle des Ladevorgangs des Elektrofahrzeugs und / oder der Ladestation generiert werden. Die Lademodelle können durch die Netzwerkverbindungseinrichtung auf die Servervorrichtung hochgeladen werden, so dass andere Anwender bei Bedarf die Lademodelle aus der Servervorrichtung herunterladen können. Sind Lademodelle auf der Servervorrichtung bereits vorhanden, können die Lademodelle durch die Netzwerkverbindungseinrichtung direkt heruntergeladen und auf der Modellierungsvorrichtung abgespielt werden. Es ist vorteilhaft, dass die Lademodelle weiterhin durch die Netzwerkverbindungseinrichtung zur Emulationsvorrichtung übertragbar sind. Damit kann das Elektrofahrzeug und / oder die Ladestation mit einem Satz von Lademodellen effizient nachgebildet werden.

In einer weiteren vorteilhaften Weiterbildung kann eine Aufteilungsvorrichtung umfasst sein, die eingerichtet ist, Messdaten nach einer vordefinierten Verhaltensweise des Elektrofahrzeugs und / oder der Ladestation aufzuteilen, insbesondere in Aktions- und Reaktionsdaten. Dies dient zu einer realitätsnäheren Abbildung des Lademodells, da das Laden zwischen der Ladestation und dem Elektrofahrzeug aus einer Aktion und Reaktion bestehen kann. Um verschiedene Reaktionen der Ladestation zu messen und zu protokollieren, können verschiedene Elektrofahrzeuge an die Ladestation angeschlossen werden. Die Messdaten können nach Aktion und Reaktion aufgeteilt und in der Aufteilungsvorrichtung abgespeichert werden. Sobald ein Elektrofahrzeug an die Ladestation angeschlossen ist, können die in der Aufteilungsvorrichtung abgespeicherten Aktionsdaten gemäß der Aktion des zu prüfenden Elektrofahrzeugs geprüft werden, so dass festgelegt werden kann, ob hierzu eine gleiche oder gegebenenfalls ähnliche Aktion durchgeführt werden kann. Dann können die an die Aktion des Elektrofahrzeugs anpassenden Reaktionsdaten ausgewählt und die entsprechende Reaktion der Ladestation für das zu prüfende Elektrofahrzeug abgespielt werden, um die Ladestation als Lademodell nachzubilden. Wird keine gleiche oder ähnliche Aktion gefunden, kann eine vordefinierte Standard-Reaktion erfolgen.

In einer weiteren vorteilhaften Weiterbildung kann die Aufteilungsvorrichtung zumindest eine Netzwerkverbindungseinrichtung zum Auslesen und / oder Übergeben bzw. Herunterladen und / oder Hinaufladen der Messdaten aus der Messvorrichtung und / oder Modellierungsvorrichtung und / oder der Servervorrichtung, und zumindest eine Aufteilungseinrichtung zur Durchführung einer vordefinierbaren Datenaufteilung umfassen. Es ist vorteilhaft, dass in der Aufteilungsvorrichtung zumindest eine Netzwerkverbindungseinrichtung umfasst ist. Hierdurch können die Anwender die Messdaten, insbesondere die Aktion- und Reaktionsdaten herunterladen, so dass die Anwender keine gegenständlichen Elektrofahrzeuge an die Ladestation zum Erfassen der Reaktionsdaten der Ladestation bringen müssen. Die Aufteilungsweise der Messdaten und / oder Lademodelle kann durch die Aufteilungseinrichtung automatisch oder durch einen Anwender vorgenommen werden.

In einer weiteren vorteilhaften Weiterbildung kann die Aufteilungseinrichtung in die Modellierungsvorrichtung umfasst sein, um Aktions- und Reaktionsdaten (AD, RD) unterschieden verwerten zu können. Damit kann das Elektromobilitäts-Ladetestsystem kompakt aufgebaut und Gerätebauraum eingespart werden.

In einer weiteren vorteilhaften Weiterbildung können in der Modellierungsvorrichtung zumindest eine Analyseeinrichtung und / oder eine Simulationseinrichtung umfasst sein, wobei durch die Analyse- und / oder die Simulationseinrichtung die in Aktions- und Reaktionsdaten aufteilbaren Messdaten analysierbar und die elektrischen Verhaltensweisen, Protokollparameter und Kommunikationsinhalte des Ladevorgangs des Elektrofahrzeugs und / oder der Ladestation simulierbar sind. Hierbei können die aufgezeichneten Messdaten der Ladestation und / oder des Elektrofahrzeugs als Log-Dateien gespeichert werden. Diese können durch die Analyseeinrichtung analysiert werden. So können z.B. eine Analyse hinsichtlich Normkonformität beispielsweise nach zumindest einer der folgenden Normen IEC 61851-1, 61851-23, DIN 70121, ISO 15118, SAE J1772, CHAdeMO, GBIT, ChaoJi oder anderen nationalen oder anwendungsbasierten Standards durchgeführt und bewertet werden, ein Fehlverhalten beim Signalverhalten, beim Protokoll oder beim Energietransport erkannt und/oder durchschnittliche Parameter der Signale, Protokollinhalte oder des Energietransports ausgewertet werden, auch können Bewertungen hinsichtlich des technischen oder normkonformen Zustands des konkreten Elektrofahrzeugs und/oder der konkreten Ladestation (Ladesäule, Wallbox etc.) vorgenommen werden. Das Signalverhalten kann auf der physikalischen Ebene im Rahmen eines Low-Level Signalverhaltens, insbs. bzgl. der Strom- und Spannungsverläufe analysiert werden, und / oder es können informationstechnische Inhalte, insbesondere High-Level Kommunikationsinhalte analysiert werden. Daneben können die elektrischen Verhaltensweisen, Protokollparameter und Kommunikationsinhalte des Ladevorgangs des Elektrofahrzeugs und / oder der Ladestation simuliert werden. Die Simulation kann die erwartete Eingabe und erzeugte Ausgabe von Signalen umfassen, die von einem zu simulierenden Elektrofahrzeug bzw. einer Ladestation erwartbar sind. Auch kann die Simulation die Simulation eines oder mehrerer Fehlerfallszenarios einer zu simulierenden Ladestation / eines zu simulierenden Elektrofahrzeugs umfassen, um eine spezifikationsgemäßes Verhalten der konkret angeschlossen Elektrofahrzeug / Ladestation als Reaktion zu testen. Elektromobilitäts-Ladetestsystems an das Elektrofahrzeug und / oder an die Ladestation können die Simulationsdaten bzw. die generierten Lademodelle der Ladestation an das Elektrofahrzeug und / oder die Simulationsdaten bzw. die generierten Lademodelle des Elektrofahrzeugs an die Ladestation gesendet werden. Damit kann es überprüft werden, wie das reale Elektrofahrzeug und / oder die reale Ladestation entsprechend auf die "aufgezeichnete" Ladestation und / oder das "aufgezeichnete" Elektrofahrzeug reagieren und inwieweit Anpassungen bzw. Toleranzerhöhungen an das Elektrofahrzeug benötigt werden sollen, um diese Ladestation zu "verstehen". Weiterhin können benötigte Optimierungen der Software aufgezeigt werden. Alle dadurch extrahierten Datensätze sind mit der Modellierungsvorrichtung kompatibel, so dass die älteren, bereits archivierten Log-Dateien für die Messdatenextraktion bzw. die Messdatensimulation verwendet und ohne Umwege zum Testen benutzt werden können.

In einer weiteren vorteilhaften Weiterbildung kann die Emulationsvorrichtung zumindest eine Netzwerkverbindungseinrichtung zum Herunterladen der Messdaten und / oder der Lademodelle und zumindest eine Emulationseinrichtung umfassen, wobei durch die Emulationseinrichtung die aufgezeichneten bzw. modellierten elektrische Verhaltensweisen, Protokollparameter und Kommunikationsinhalte des Ladevorgangs des Elektrofahrzeugs und / oder der Ladestation nachahmbar bzw. emulierbar sind. Mit einem Lademodell - oder durch Messdaten kann ein "virtuelles" Elektrofahrzeug und / oder eine "virtuelle" Ladestation nachgeahmt und eine "echte" bzw. gegenständliche Ladestation und / oder ein "echtes" bzw. gegenständliches Elektrofahrzeug geprüft werden.

In einer weiteren vorteilhaften Weiterbildung kann die Emulationseinrichtung eine Auswahleinrichtung umfassen, die eingerichtet ist, die von der Servervorrichtung heruntergeladenen Messdaten von der Auswahleinrichtung aufzuteilen, insbesondere in Aktions- und Reaktionsdaten aufzuteilen, wodurch vor der Emulation eine angepasste elektrische Verhaltensweise, Protokollparameter und Kommunikationsinhalte für eine realitätsnahe Nachbildung des Elektrofahrzeugs und / oder der Ladestation manuell, automatisch oder halbautomatisch bereitstellbar sind. Es ist alternativ vorteilhaft denkbar, dass die Emulation nicht zu 100% die Wirklichkeit abbildet, sondern sehr viele reale Bedingungen zumindest annähernd nachstellen kann. Es ist weiterhin vorteilhaft, dass durch die von der Auswahleinrichtung durchgeführte Aufteilung der Messdaten in Aktions- und Reaktionsdaten ein an das zu prüfende Objekt angepasste virtuelle Nachbildung bereitstellt wird.

In der Regel kann die Messvorrichtung und die Modellierungsvorrichtung baulich bzw. räumlich getrennt sein, und über standardisierte Datenschnittstellen miteinander verbunden sein, In einer weiteren vorteilhaften Weiterbildung können die Messvorrichtung und die Modellierungsvorrichtung baulich in einem Gehäuse umfasst sein. Damit kann ein kompakter Aufbau des Elektromobilitäts-Ladetestsystems erreicht werden.

In der Regel kann die Modellierungsvorrichtung und die Emulationsvorrichtung baulich bzw. räumlich getrennt sein, und über standardisierte Datenschnittstellen miteinander verbunden sein. In einer weiteren vorteilhaften Weiterbildung können die Modellierungsvorrichtung und die Emulationsvorrichtung baulich in einem Gehäuse umfasst sein. Dadurch kann vorteilhaft erreicht werden, ein kompakter Aufbau des Elektromobilitäts-Ladetestsystems zu erstellen.

In einer weiteren vorteilhaften Weiterbildung kann die Servervorrichtung zumindest teilweise als cloudbasierter Internetserver ausgeführt sein, wobei bevorzugt ein Zugriff auf die Servervorrichtung durch eine Zugriffskontrolleinrichtung beschränkt und kontrollierbar ist. Dadurch kann eine platzsparende Bauweise des Elektromobilitäts-Ladetestsystems erzielt werden, und der weltweite Austausch der Messdaten oder Lademodelle über eine Online-Austauschplattform vereinfacht werden.

In einer weiteren vorteilhaften Weiterbildung können die Modellierungsvorrichtung und/oder die Aufteilungsvorrichtung in der Servervorrichtung angeordnet sein. Somit kann an zentraler Stelle eine Aufbereitung der Messdaten Aktions- und Reaktionsdaten und / oder die Generierung eines Lademodells erreicht und somit Softwareupdates erleichtert, Rechenzeit gespart und der Datenaustausch effizient gestaltet werden, insbesondere bei einer internetbasierten Servervorrichtung, die als Online-Austauschplattform dient.

Vorteilhaft kann ein Selbsttest des Lademodells einer Ladestation und eines Elektrofahrzeugs durchführbar sein, wobei das Ladetestsystem sowohl Ladestation als auch Elektrofahrzeug emuliert und Tests der Interoperabilität basierend auf den Lademodellen von Fahrzeug und Ladestation durchführt. Somit kann die Validität des Lademodells überprüft werden, dies kann vorteilhaft durch die Modellierungsvorrichtung, die vorzugsweise in der Servervorrichtung integriert ist, durchgeführt werden.

In einer weiteren vorteilhaften Weiterbildung können die Messdaten und / oder das Lademodell Metadaten über das Elektrofahrzeugs und / oder die Ladestation umfassen, die bei Messung zwischen der Ladestation und dem Elektrofahrzeug durch die Messvorrichtung erfasst werden, insbesondere Gerätehersteller, Gerätetyp, Herstellungsdatum, Seriennummer, Softwareversion, Aufzeichnungsdatum, Geräteabbildung/Fotos, Typenschild, Gerätestandort, Batteriekapazität und / oder Batterie-Innenwiderstand, sowie Informationen zur Messvorrichtung wie Gerätetyp, Firmware-Version, Gerätehersteller, Hardwareversion, und / oder Software-Umfang. Die Metadaten können automatisch erfasst, z.B. durch Scannen eines QR-Codes oder RFID-TAGs oder durch einen Anwender manuell eingegeben und beim Modellieren berücksichtigt werden.

In einem nebengeordneten Aspekt betrifft die Erfindung ein Elektromobilitäts-Ladetestverfahren zum Generieren und Austausch von Messdaten und / oder Lademodellen von elektrischen Verhaltensweise, insbesondere Spannungs- und / oder Stromverhalten, Protokollparametern und Kommunikationsinhalten eines Ladevorgangs eines Elektrofahrzeugs und / oder einer Ladestation sowie zum Prüfen der Kommunikationsfähigkeit des Elektrofahrzeugs und / oder der Ladestation, insbesondere durch ein Elektromobilitäts-Ladetestsystem. Das Elektromobilitäts-Ladetestsystem umfasst folgende Schritte:
- Messen der elektrischen Verhaltensweisen, Protokollparameter und Kommunikationsinhalte des Ladevorgangs des Elektrofahrzeugs und / oder der Ladestation durch die Messvorrichtung, wobei die Messdaten in Aktions- und Reaktionsdaten aufgeteilt werden;
- Automatisiertes Generieren eines Lademodells des Ladevorgangs für die Aktions- und Reaktionsdaten durch die Modellierungsvorrichtung basierend auf die erfassten Messdaten wodurch das Lademodell elektrofahrzeugseitig oder ladestationsseitig generiert wird;
- Hochladen der Messdaten und / oder des Lademodells auf die Servervorrichtung über ein Netzwerk;
- Herunterladen der Messdaten und des Lademodells mittels der Emulationsvorrichtung über das Netzwerk oder direktes Empfangen von der Modellierungsvorrichtung oder der Messvorrichtung;
- Emulieren des Ladevorgangs durch die Emulationsvorrichtung durch Abspielen der in Aktions- und Reaktionsdaten aufgeteilten Messdaten und des entsprechend generierten Lademodells auf die Emulationsvorrichtung.

Mit einem derartigen Elektromobilitäts-Ladetestverfahren lassen sich die bezüglich des erfindungsgemäßen Systems beschriebenen Vorteile ebenfalls erreichen.

In einer vorteilhaften Weiterbildung des Elektromobilitäts-Ladetestverfahrens können die Lademodelle - und / oder Messdaten auf der Emulationsvorrichtung manuell, automatisiert oder halbautomatisiert emuliert werden.

In einer weiteren vorteilhaften Weiterbildung können vor dem Hochladen von Messdaten auf die Servervorrichtung die Messdaten mittels einer Aufteilungsvorrichtung, insbesondere einer Aufteilungseinrichtung nach einer vordefinierten Verhaltensweise des Elektrofahrzeugs und / oder der Ladestation aufgeteilt, insbesondere nach Aktions- und Reaktionsdaten aufgeteilt werden. Vorteilhafterweise können die Messdaten und / oder Lademodelle nach Aktion und Reaktion aufgeteilt und in der Aufteilungsvorrichtung abgespeichert werden. Hierdurch ist eine Trennung der vom Elektrofahrzeug 50 oder der Ladesäule 52 abgegebenen Kommunikationsdaten möglich.

In einer weiteren vorteilhaften Weiterbildung können die Aktions- und Reaktionsdaten in einer oder mehreren Datenbanken aufbereitet werden, um so die große Anzahl an Aktions- und Reaktionsdaten eines oder vieler Elektrofahrzeuge bzw. einer oder vieler Ladestationen strukturiert zu verarbeiten und schnell abrufen zu können.

In einer weiteren vorteilhaften Weiterbildung können vor dem Hochladen der Messdaten auf die Servervorrichtung die Messdaten mittels einer Analyseeinrichtung analysiert und die elektrischen Verhaltensweisen, Protokollparameter und Kommunikationsinhalte des Ladevorgangs des Elektrofahrzeugs und / oder der Ladestation mittels der Simulationseinrichtung simuliert werden.

In einer weiteren vorteilhaften Weiterbildung kann ein Zugriff auf die Servervorrichtung über eine Zugriffskontrolleinrichtung gesteuert werden. Dadurch kann die Servervorrichtung in einem sicherheitsgeschützten Netzwerk insbesondere als zugriffsgeschützte Online-Austauschplattform bereitgestellt sein, wodurch verschiedene Zugriffs- und Tarifierungs- bzw. Bezahlmodelle ermöglicht werden.

### ZEICHNUNGEN

Weitere Vorteile ergeben sich aus den Figuren und der zugehörigen Zeichnungsbeschreibung. In den Figuren sind Ausführungsbeispiele der Erfindung dargestellt. Die Figuren, die Beschreibung und die Ansprüche enthalten zahlreiche Merkmale in Kombinationen. Der Fachmann wird diese Merkmale zweckmäßigerweise auch einzeln betrachten und zu sinnvollen weiteren Kombinationen zusammenfassen. Es zeigen:
- **Fig. 1**: eine schematische Darstellung eines Ausführungsbeispiels eines erfindungsgemäßen Elektromobilitäts-Ladetestsystems;
- **Fig. 2**: eine schematische Darstellung einer Messvorrichtung gemäß einer Ausführungsform;
- **Fig. 3a,b**: zwei schematische Darstellungen von Modellierungsvorrichtungen gemäß Beispiele;

- **Fig. 4a,** b: zwei schematische Darstellungen von Modellierungsvorrichtungen gemäß Beispiele;

- **Fig. 5a,b**: zwei schematische Darstellungen von Modellierungsvorrichtungen gemäß Beispiele;

- **Fig. 6a,b**: zwei schematische Darstellungen von Emulationsvorrichtungen gemäß von Ausführungsformen;
- **Fig. 7**: eine schematische Darstellung eines Ausführungsbeispiels eines erfindungsgemäßen Elektromobilitäts-Ladetestsystems;
- **Fig. 8a,b**: zwei schematische Darstellungen von Aufteilungsvorrichtungen gemäß von Beispielformen;
- **Fig. 9**: eine schematische Darstellung einer Emulationsvorrichtung gemäß einer Ausführungsform;
- **Fig. 10**: eine schematische Darstellung der Interoperabilität verschiedener Elektrofahrzeuge und verschiedener Ladestationen;
- **Fig. 11**: eine schematische Darstellung der Interoperabilität eines Ausführungsbeispiels eines erfindungsgemäßen Elektromobilitäts-Ladetestsystems, angeschlossen an diverse Elektrofahrzeuge und Ladestationen;
- **Fig. 12**: eine schematische Darstellung eines Ausführungsbeispiels eines erfindungsgemäßen Elektromobilitäts-Ladetestsystems;
- **Fig. 13**: eine schematische Darstellung eines Ausführungsbeispiels eines erfindungsgemäßen Elektromobilitäts-Ladetestsystems;
- **Fig. 14**: eine schematische Darstellung eines Ausführungsbeispiels eines erfindungsgemäßen Elektromobilitäts-Ladetestsystems;
- **Fig. 15**: eine schematische Darstellung eines Ausführungsbeispiels eines erfindungsgemäßen Elektromobilitäts-Ladetestsystems;
- **Fig. 16**: eine schematische Darstellung eines Ausführungsbeispiels eines erfindungsgemäßen Elektromobilitäts-Ladetestsystems;
- **Fig. 17**: eine schematische Darstellung eines Mess- und Modellierungsvorgangs mittels eines Beispiels eines erfindungsgemäßen Elektromobilitäts-Ladetestsystems;
- **Fig. 18**: eine schematische Darstellung eines Mess- und Modellierungsvorgangs mittels eines Beispiels eines erfindungsgemäßen Elektromobilitäts-Ladetestsystems;
- **Fig. 19**: eine schematische Darstellung eines Mess- und Modellierungsvorgangs mittels eines Beispiels eines erfindungsgemäßen Elektromobilitäts-Ladetestsystems;
- **Fig. 20**: eine schematische Darstellung eines Mess- und Modellierungsvorgangs mittels eines Beispiels eines erfindungsgemäßen Elektromobilitäts-Ladetestsystems;
- **Fig. 21**: eine schematische Darstellung eines Mess- und Modellierungsvorgangs mittels eines Beispiels eines erfindungsgemäßen Elektromobilitäts-Ladetestsystems;
- **Fig. 22**: eine schematische Darstellung eines Mess- und Modellierungsvorgangs mittels eines Beispiels eines erfindungsgemäßen Elektromobilitäts-Ladetestsystems;
- **Fig. 23**: eine schematische Darstellung eines Beispiels eines erfindungsgemäßen Elektromobilitäts-Ladetestsystems mit einem AC-Elektrofahrzeug;
- **Fig. 24**: eine schematische Darstellung des in Fig. 22 dargestellten Beispiels eines erfindungsgemäßen Elektromobilitäts-Ladetestsystems mit einem DC-Elektrofahrzeug;
- **Fig. 25**: eine schematische Darstellung eines Beispiels eines erfindungsgemäßen Elektromobilitäts-Ladetestsystems; mit einer AC-Ladestation und
- **Fig. 26**: eine schematische Darstellung eines Beispiels eines erfindungsgemäßen Elektromobilitäts-Ladetestsystems mit einer DC-Ladestation.

In den Figuren sind gleiche oder gleichartige Komponenten mit gleichen Bezugszeichen beziffert.

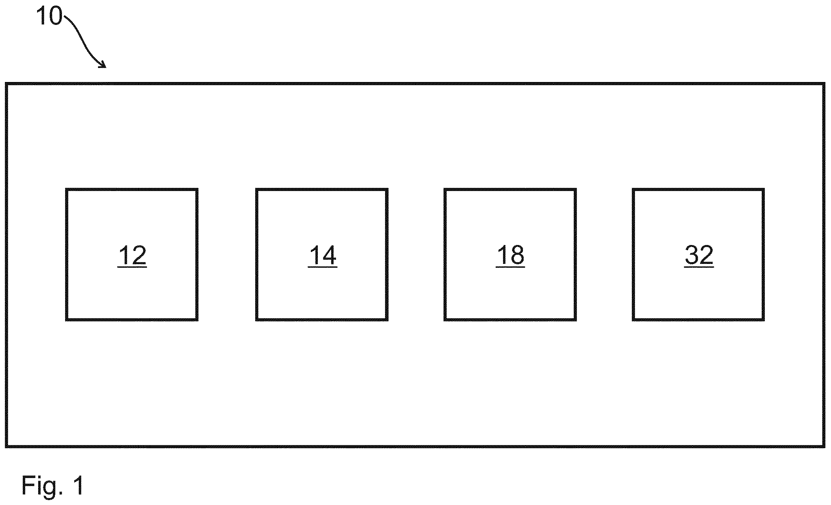

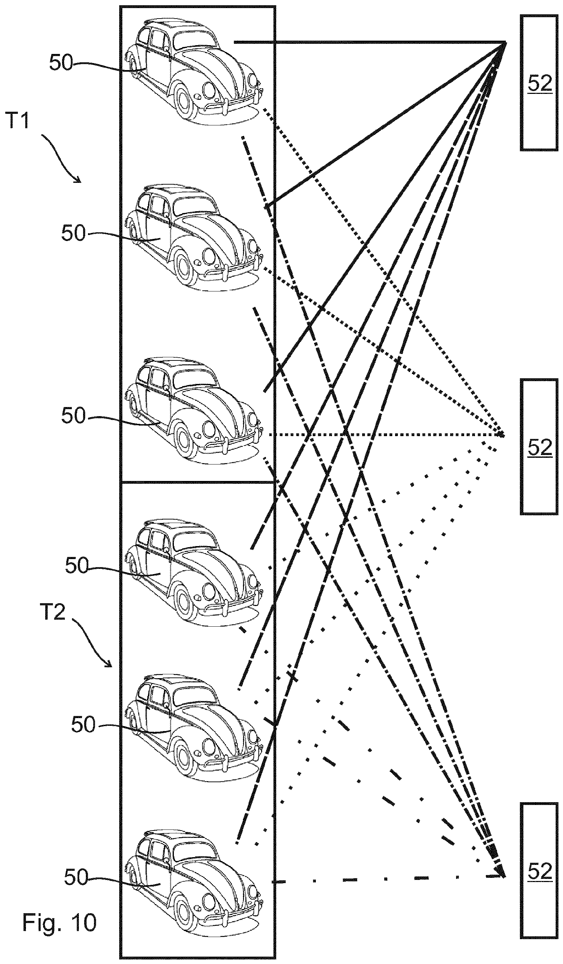

Fig. 1 stellt ein Elektromobilitäts-Ladetestsystem 10 zum Generieren und Austausch von Messdaten 58 und / oder Lademodelle von elektrischen Verhaltensweisen, insbesondere Spannungs- und / oder Stromverhalten, Protokollparametern und Kommunikationsinhalten eines Ladevorgangs eines in Fig. 10 dargestellten Elektrofahrzeugs 50 und / oder einer Ladestation 52 sowie zum Prüfen der Kommunikationsfähigkeit des Elektrofahrzeugs 50 und / oder der Ladestation 52 dar. Das Elektromobilitäts-Ladetestsystem 10 umfasst eine Messvorrichtung 12 zur Bereitstellung von Messdaten 58 der elektrischen Verhaltensweisen, Protokollparameter und Kommunikationsinhalte des Ladevorgangs des Elektrofahrzeugs 50 und / oder der Ladestation 52, eine Modellierungsvorrichtung 14 zum Erzeugen eines Lademodells des Ladevorgangs, eine Servervorrichtung 18 zum Abspeichern und Bereitstellen einer Austauschmöglichkeit der Messdaten 58 und / oder Lademodelle, und eine Emulationsvorrichtung 32 zum Herunterladen der Messdaten 58 und des Lademodells 60 von der Messvorrichtung 12, und / oder der Modellierungsvorrichtung 14, und / oder der Servervorrichtung 18 und zum Emulieren des Ladevorgangs der Ladestation 52 und / oder des Elektrofahrzeugs 50 durch Abspielen der Messdaten 58 und des Lademodells 60. Das Elektromobilitäts-Ladetestsystem 10 kann als ein in einem Gehäuse integrierten Gerät, oder als verteiltes System mit räumlich auseinanderliegenden Einzelgeräten ausgebildet sein.

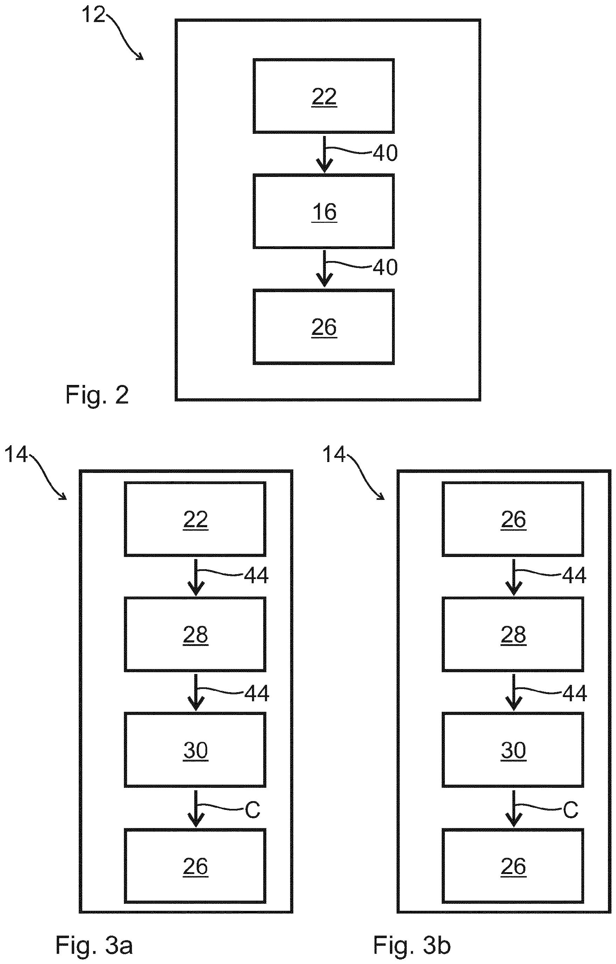

In Fig. 2 ist die in Fig. 1 gezeigte Messvorrichtung 12 schematisch in Einzelheiten dargestellt. Die Messvorrichtung 12 umfasst eine Schnittstelleneinrichtung 22, eine Aufzeichnungseinrichtung 16 und eine Netzwerkverbindungseinrichtung 26. Über die Schnittstelleneinrichtung 22 kann das Elektrofahrzeug 50 an die Ladestation 52 angeschlossen sein. Die Schnittstelleneinrichtung 22 kann beispielsweise als Ladestecker bzw. Ladekupplung eines Elektrofahrzeugs bzw. einer Ladesäule ausgeführt sein. Die Messdaten 58 sind bei einem Messvorgang 40 mittels der Aufzeichnungseinrichtung 16 durch die Schnittstelleneinrichtung 22 protokollierbar und lassen sich durch die Netzwerkverbindungseinrichtung 26 auf die Servervorrichtung 18 hochladen und / oder zur Modellierungsvorrichtung 14 übertragen. Eine Schnittstelleneinrichtung 22 kann beispielsweise Strom- und Spannungswerte erfassen oder erzeugen bzw. einspeisen, also bidirektional Messdaten abgreifen oder Signale ausgeben und bildet die Schnittstelle für die Messdatenerfassung und Emulationssignal-Ein- und Ausgabe. Somit können bei der Emulation Aktionen und Reaktionen gegenüber einem Elektrofahrzeug 50 bzw. einer Ladesäule 52 abgegeben bzw. empfangen werden, und in der Messdatengewinnung Energieströme und Kommunikationsdaten aufgezeichnet werden.

Die in Fig. 1 dargestellte Ausführungsform einer Modellierungsvorrichtung 14 umfasst weiterhin nach Fig. 3a eine Schnittstelleneinrichtung 22 zur Messdatenerfassung, eine Aufbereitungseinrichtung 28, eine Modellierungseinrichtung 30 und eine Netzwerkverbindungseinrichtung 26. Bei Integration in einem Gehäuse können Messvorrichtung 12 und Modellierungsvorrichtung 14 auf dieselbe Schnittstelleneinrichtung 22 und Netzwerkverbindungseinrichtung 26 zugreifen, und ein Datenaustausch zwischen Messvorrichtung 12 und Modellierungsvorrichtung 14 kann direkt erfolgen. Ansonsten kann die Modellierungsvorrichtung 14 durch die Schnittstelleneinrichtung 22 mit der Messvorrichtung 12 elektrisch verbindbar sein, oder direkt Messdaten erfassen, so dass während eines Modellierungsvorgangs 44 die Messdaten 58 über die Schnittstelleneinrichtung 22 zur Modellierungseinrichtung 30 übertragen werden können. Die Messdaten 58 werden zunächst durch die Aufbereitungseinrichtung 28 zu einem an das Lademodell angepassten Datenformat verarbeitet. Anschließend können die Messdaten 58 durch die Modellierungseinrichtung 30 modelliert und dadurch das Lademodellgeneriert werden, welches geeignet ist, eine emulationsfähige Nachbildung des Elektrofahrzeugs 50 bzw. der Ladesäule 52 darzustellen. Das Lademodell kann durch die Netzwerkverbindungseinrichtung 26 auf die Servervorrichtung 18 durch einen Hochladevorgang C hochgeladen und / oder zur Emulationsvorrichtung 32 direkt übertragen werden.

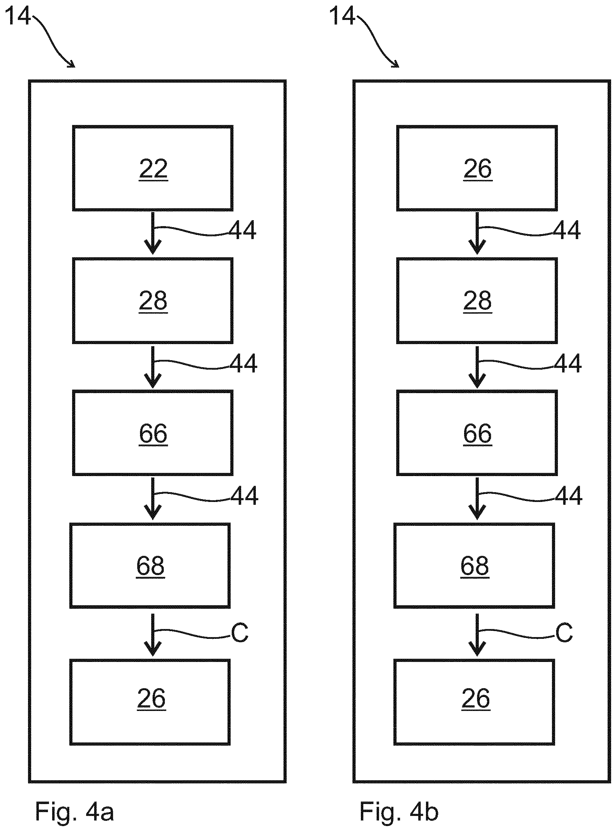

Alternativ zur Modellierungsvorrichtung 14 in Fig. 3a kann die in Fig. 4a gezeigte Modellierungsvorrichtung 14 in dem Elektromobilitäts-Ladetestsystem 10 eingesetzt werden. In der Modellierungsvorrichtung 14 sind eine Schnittstelleneinrichtung 22 zur Messdatenaufnahme, eine Aufbereitungseinrichtung 28, eine Analyseeinrichtung 66, eine Simulationseinrichtung 68 und eine Netzwerkverbindungseinrichtung 26 angeordnet. Zwischen der Aufbereitungseinrichtung 28 und der Analyseeinrichtung 66 ist eine Aufteilungseinrichtung 36 eingeschaltet. Durch die Aufteilungseinrichtung 36 können Messdaten 58 nach einer vordefinierten Verhaltensweise des Elektrofahrzeugs 50 und / oder der Ladestation 52 aufgeteilt, insbesondere nach Aktions- und Reaktionsdaten aufgeteilt werden. Die aufgeteilten Messdaten 58 können durch die Analyseeinrichtung 66 analysiert und die elektrischen Verhaltensweisen, Protokollparameter und Kommunikationsinhalte des Ladevorgangs des Elektrofahrzeugs 50 und / oder der Ladestation 52 durch die Simulationseinrichtung 68 simuliert werden. Dadurch können die Lademodelle 60 generiert werden. Zum Hochladen C der Lademodelle 60 werden diese von der Modellierungseinrichtung 30 zur Netzwerkverbindungseinrichtung 26 übertragen, und von dort auf einen Server bzw. eine Datenbank hochgeladen.

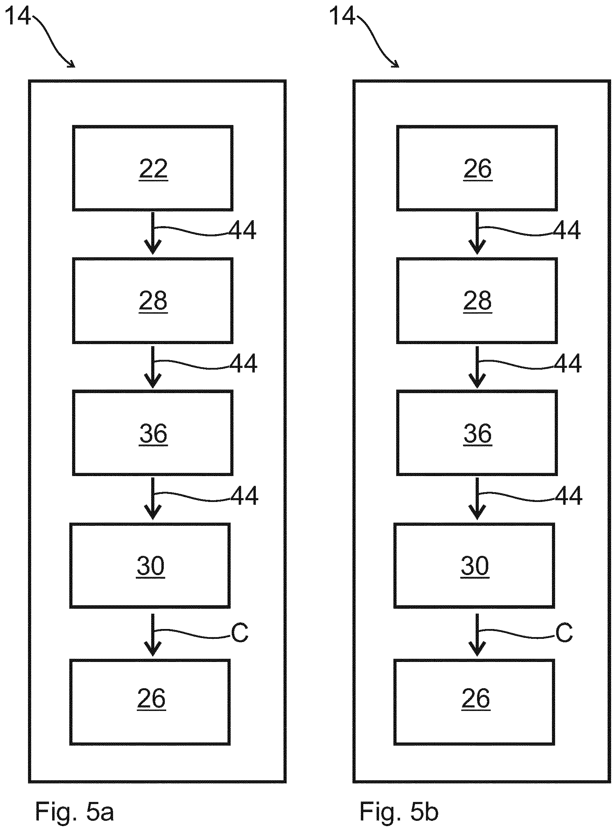

Alternativ zur Modellierungsvorrichtung 14 in Fig. 3a kann die in Fig. 5a dargestellte Modellierungsvorrichtung 14 in dem Elektromobilitäts-Ladetestsystem 10, das in Fig. 1 dargestellt ist, eingesetzt werden. In der Modellierungsvorrichtung 14 sind wie in der Ausführungsform der Modellierungsvorrichtung nach Fig. 3a eine Schnittstelleneinrichtung 22 zur Messdatenaufnahme, eine Aufbereitungseinrichtung 28, eine Modellierungseinrichtung 30 und eine Netzwerkverbindungseinrichtung 26 angeordnet. Zwischen der Aufbereitungseinrichtung 28 und der Modellierungseinrichtung 30 ist eine Aufteilungseinrichtung 36 eingeschaltet. Durch die Aufteilungseinrichtung 36 können Messdaten 58 nach einer vordefinierten Verhaltensweise des Elektrofahrzeugs 50 und / oder der Ladestation 52 aufgeteilt, insbesondere nach Aktions- und Reaktionsdaten aufgeteilt werden. Dies erleichtert die Modellbildung erheblich, da die Kommunikationssignale nach Sender aufgeteilt sind. Zum Hochladen C des Lademodells 60 werden diese von der Modellierungseinrichtung 30 zur Netzwerkverbindungseinrichtung 26 übertragen, und von dort auf einen Server bzw. eine Datenbank hochgeladen.

Alternativ zu den vorstehenden Ausführungsformen einer Modellierungsvorrichtung 14 nach Fig. 3a, Fig. 4a oder Fig. 5a können gemäß den in den in den Figs. 3b, 4b oder 5b dargestellten anstelle einer Schnittstelleneinrichtung 22, die eine unmittelbare Messdatenerfassung ermöglicht, bereits erfasste Messdaten, beispielsweise durch eine Messvorrichtung 12 nach Fig. 2 erfasste Messdaten, über die eine oder eine zweite Netzwerkverbindungseinrichtung 26 aus einer Speichervorrichtung 24 bzw. einer Servereinrichtung 18, beispielsweise einem externen Cloudspeicher, oder direkt aus der externen Messvorrichtung 12 nach Fig. 2 empfangen werden. Somit kann auf eine Schnittstelleinrichtung 22 verzichtet werden. Die Modellierungsvorrichtung 14 kann somit extern von der Messvorrichtung 12, beispielsweise zentral in einer Internetserverapplikation oder einem externen Messgerät, das Daten der Messvorrichtung 12 über ein Netzwerk oder einem Speicher erhält, umfasst sein.

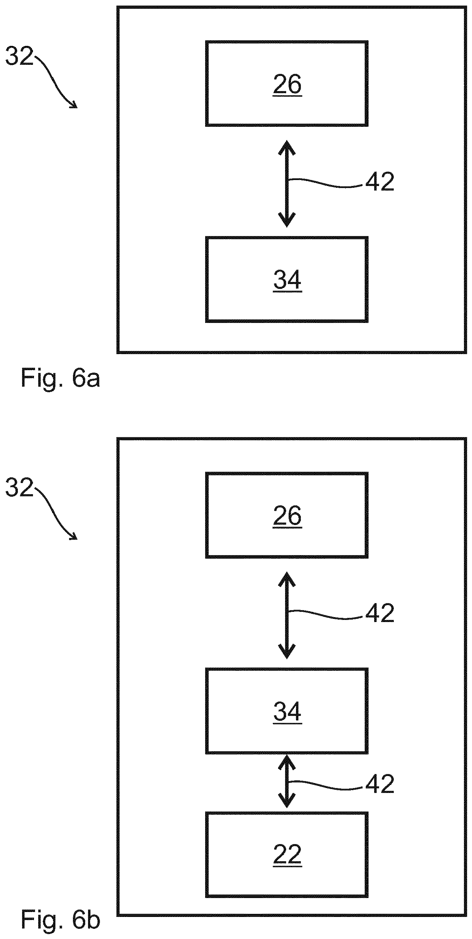

Fig. 6a und 6b zeigen schematisch Ausführungsformen einer Emulationsvorrichtung 32, die zum Abspielen eines Lademodells 60 - oder Messdaten 58 zur Wiedergabe eines Ladeverhaltens eines Elektrofahrzeugs 50 oder einer Ladesäule 52 dient, im Detail. Hierzu umfasst die Emulationsvorrichtung 32 eine Netzwerkverbindungseinrichtung 26 und eine Emulationseinrichtung 34. Durch die Netzwerkverbindungseinrichtung 26 können Messdaten 58 und / oder das Lademodell 60 aus der Servervorrichtung 18 heruntergeladen und zur Emulationseinrichtung 34 übermittelt werden, sofern diese nicht in einem Gehäuse integriert sind. Während eines Emulationsvorgangs 42 können die gemessenen bzw. modellierten elektrischen Verhaltensweisen, Protokollparameter und Kommunikationsinhalte des Ladevorgangs des Elektrofahrzeugs 50 und / oder der Ladestation 52 emuliert, d.h. nachgebildet und mittels der Netzwerkverbindungseinrichtung 26 - siehe Fig. 6a - wieder zurückgespielt werden, um eine Kommunikation des Ladeverfahrens mit einer Ladestation 52 bzw. Fahrzeug 50 nachzubilden. Somit kann eine Emulation des Ladeverhaltens in einem Stand-Alone-Gerät durchgeführt werden.

Alternativ kann, wie in Fig. 6b dargestellt, die Emulation durch die Schnittstelleneinrichtung 22 physikalisch verbunden gegenüber einem Elektrofahrzeug 50 oder Ladesäule 52 als Gegenpart abgespielt werden.

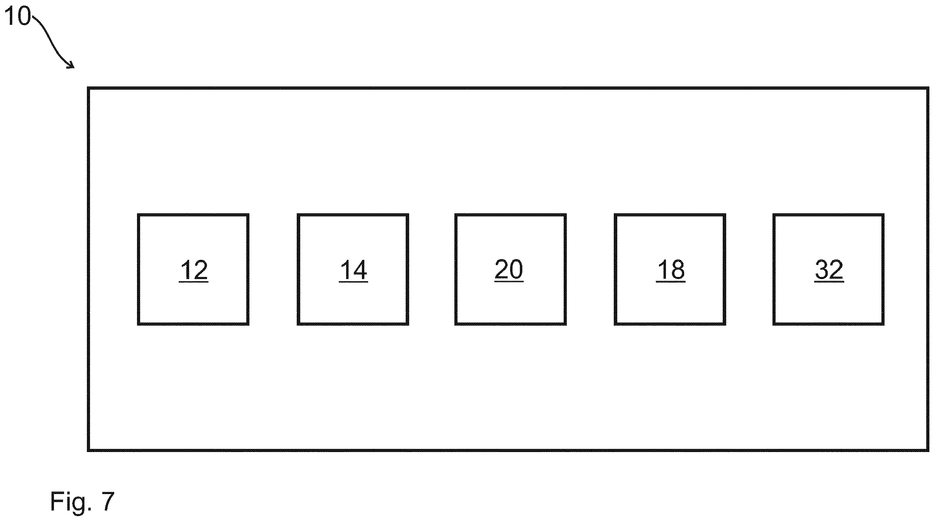

Im Vergleich zu Fig. 1 stellt Fig. 7 eine weitere Ausführungsform eines Elektromobilitäts-Ladetestsystems 10 dar, in dem zwischen eine Modellierungsvorrichtung 14 und einer Servervorrichtung 18 eine Aufteilungsvorrichtung 20 vorgesehen ist. Mittels der Aufteilungsvorrichtung 20 können von der Modellierungsvorrichtung 14 empfangen Messdaten 58 der Servervorrichtung 18 vor Erstellung des Lademodells 60nach einer vordefinierten Verhaltensweise des Elektrofahrzeugs 50 und / oder Ladestation 52, insbesondere in Aktions- und Reaktionsdaten aufgeteilt werden.

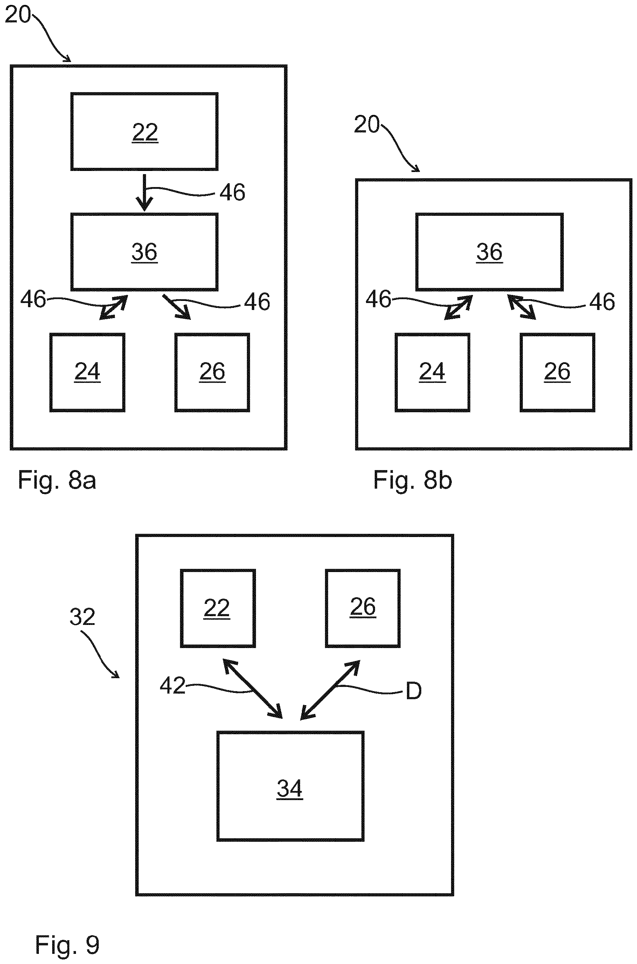

Die in Fig. 8a dargestellte Beispielform einer Aufteilungsvorrichtung 20 als Einzelgerät umfasst eine Schnittstelleneinrichtung 22, eine Aufteilungseinrichtung 36, einer Netzwerkverbindungseinrichtung 26 und eine Speichereinrichtung 24 gemäß Fig. 8a Messdaten 58 können über die Schnittstelleneinrichtung 22 während eines Ladevorgangs erfasst und zur Aufteilungsvorrichtung 20 übertragen werden. Während eines Aufteilungsvorgangs 46 sind die Messdaten 58 durch die Aufteilungseinrichtung 36 nach einer vordefinierten Verhaltensweise des Elektrofahrzeugs 50 und / oder der Ladestation 52 als Aktions- oder Reaktionsdaten aufzuteilen. Die aufgeteilten Messdaten 58 können über die Netzwerkverbindungseinrichtung 26 auf die Servervorrichtung 18 hochgeladen und / oder auf der Speichereinrichtung 24 der Aufteilungsvorrichtung 20 abgespeichert werden. Die Speichereinrichtung 24 kann Teil der Servervorrichtung 18 sein, und als lokale Servervorrichtung 18 dienen, aber auch als interner Speicher zur Messdatenauswertung, Lademodellerzeugung und Offline-Datenspeicher dienen.

Alternativ zur vorstehenden Beispielform einer Aufteilungsvorrichtung 20 nach Fig. 8a kann in der Beispielform nach Fig. 8b anstelle einer Schnittstelleneinrichtung 22, die eine unmittelbare Messdatenerfassung ermöglicht, bereits erfasste Messdaten, beispielsweise durch eine Messvorrichtung 12 nach Fig. 2 erfasste Messdaten, über die eine, oder eine zweite Netzwerkverbindungseinrichtung 26 aus einer externen Speichervorrichtung 24 bzw. einer Servereinrichtung 18, beispielsweise einem externen Cloudspeicher, oder direkt aus der externen Messvorrichtung 12 nach Fig. 2 empfangen werden. Somit kann auf eine Schnittstelleinrichtung 22 verzichtet werden. Die Aufteilungsvorrichtung 20 kann somit extern von der Messvorrichtung 12, beispielsweise zentral in einer Internetserverapplikation oder einem externen Messgerät, das Daten der Messvorrichtung 12 über ein Netzwerk oder einem Speicher erhält, umfasst sein.

In Fig. 9 ist eine Emulationsvorrichtung 32 als Einzelgerät dargestellt, in der eine Schnittstelleneinrichtung 22, eine Netzwerkverbindungseinrichtung 26 und eine Emulationseinrichtung 34 umfasst sind. Die Emulationsvorrichtung 32 ist durch die Schnittstelleneinrichtung 22 mit einer Ladesäule 52 oder einem Elektrofahrzeug 50 elektrisch verbunden, und kann das Verhalten des jeweiligen Konterparts durch Empfang und Vorgabe von Ladekommunikationsdaten und ggf. Strom- und Spannungswerte emulieren. Die abzuspielenden Messdaten 58 und / oder das Lademodell 60können über die Netzwerkverbindungseinrichtung 26 auf die Emulationsvorrichtung 32 heruntergeladen werden, wobei die Netzwerkverbindungseinrichtung 26 vorzugsweise als eine drahtlose Netzwerkverbindungseinrichtung, insbesondere eine Mobilfunk-, WLAN- oder NFC-Netzwerkverbindungseinrichtung ausgebildet ist. Messdaten 58 können von einer Auswahleinrichtung 38 der Emulationsvorrichtung 32, insbesondere in Aktions- und Reaktionsdaten aufgeteilt werden, wobei bei Empfang von Aktionsdaten des angeschlossenen Testobjektes entsprechende Reaktionsdaten ausgegeben werden können. Dadurch können vor der Emulation eine angepasste elektrische Verhaltensweise, Protokollparameter und Kommunikationsinhalte für eine realitätsnahe Nachbildung des Elektrofahrzeugs 50 und / oder der Ladestation 52 bereitgestellt sein.

In Fig. 10 sind Varianten von Fahrzeugen 50 zweier Typen T1, T2 und drei verschiedene Typen von Ladestationen 52 dargestellt, wobei ein Ladevorgang jedes Fahrzeuge 50 an jeder Ladestationen 52 im Sinne einer flächendeckenden und typübergreifenden Interoperabilität zu testen wäre. Diese zu testen würde selbst bei der dargestellten minimalen Typenvielfalt einen hohen Aufwand einer räumlichen in Verbindung bringen jedes Fahrzeugs 50 mit jeder Ladesäule 52 sowie angepasstes Testequipment bedeuten. Ziel der Erfindung ist es, die Interoperabilitätsprüfung drastisch zu vereinfachen und modellierungstechnisch die Interoperabilitätsprüfung neuer Typen von Fahrzeugen 50 oder neuer Ladesäulen 52 zu vereinfachen.

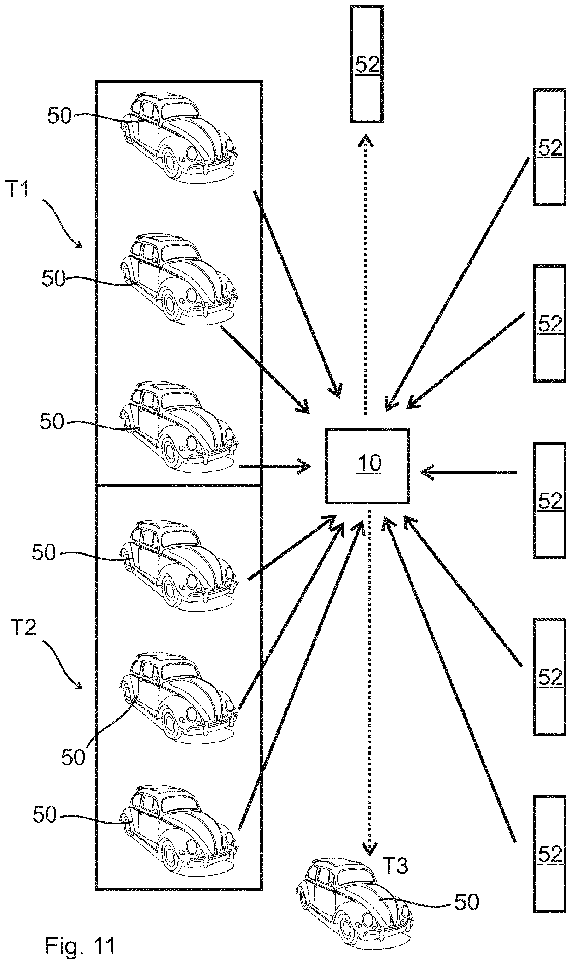

Hierzu zeigt Fig. 11 wiederum drei Varianten von Fahrzeugen 50 vom Grundtyp T1 und T2, einen neuen Fahrzeugtyp T3 und wiederum drei Typen von Ladestationen 52 die jeweils sequentiell über eine Messeinrichtung an eine Ausführungsform eines Elektromobilitäts-Ladetestsystem 10 angeschlossen werden können. Die einzelnen Ladevorgänge der Elektrofahrzeuge 50 und der Ladestation 52 können durch das Elektromobilitäts-Ladetestsystem 10 emuliert werden. Hierzu ist es notwendig, dass einmalig ein Ladevorgang jeder Fahrzeugvariante 50 mit jeder Ladesäulenvariante 52 durch das Ladetestsystem 10 aufgezeichnet wird. Hiernach können auch ohne physische Anwesenheit des Gegenparts jedes Elektrofahrzeug 50 - auch neue Varianten T3 bzw. jede Ladesäule 52, auch neue Varianten getestet werden. Da ein Austausch der Messdaten 58 und/oder der Lademodelle 60 über einen zentralen Internetserver erfolgen kann, kann jeder Ladesäulen- oder Fahrzeughersteller überall auf der Welt jedes noch so entfernte Fahrzeug bzw. Ladesäule auf Interoperabilität testen.

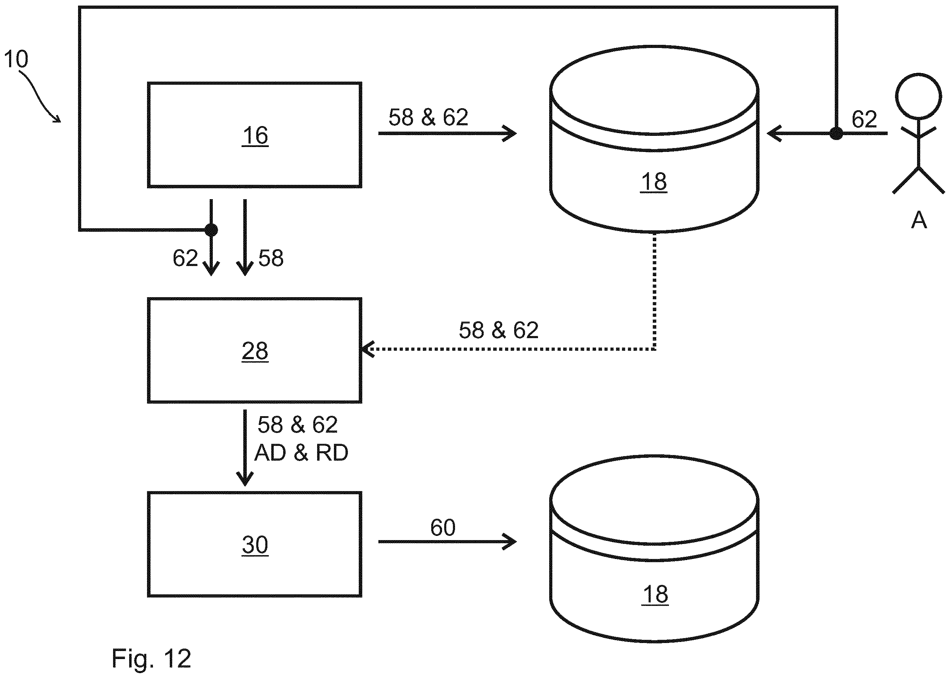

Gemäß Fig. 12 können elektrische Verhaltensweisen, Protokollparameter und Kommunikationsinhalte eines Ladevorgangs eines Elektrofahrzeugs 50 und / oder der Ladestation 52 durch eine Ausführungsform des Ladetestsystems 10 von einer Aufzeichnungseinrichtung 16 einer Messvorrichtung 12 protokolliert werden. Die Messdaten 58 können zu einer Aufbereitungseinrichtung 28 einer Modellierungsvorrichtung 14 übertragen werden, wobei mittels der Aufbereitungseinrichtung 28 die Messdaten 58 in Aktionsdaten AD und Reaktionsdaten RD sowie zu einem an das Lademodell 60 angepassten Datenformat verarbeitet werden können. Die Messdaten 58 können weiter zu einer Modellierungseinrichtung 30 der Modellierungsvorrichtung 14 übermittelt werden. Dadurch kann der Ladevorgang modelliert werden und somit können Lademodelle 60basierend auf die Messdaten 58 generiert werden. Sowohl die Messdaten 58 als auch die Lademodelle 60können auf eine Servervorrichtung 18 hochgeladen. Ein Anwender A kann manuell oder halbautomatisch Metadaten 62 des Elektrofahrzeugs 50 und / oder der Ladestation 52 auf eine Servervorrichtung 18 hochladen, auch z.B. Bilder des Fahrzeugs, der Ladesäule oder des Typenschildes etc. Diese können sowohl in der Servervorrichtung 18 abgelegt, als auch mit z.B. durch die Aufzeichnungseinrichtung 16 erfassten Messdaten 58 kombiniert zur Aufbereitungseinrichtung 28 weitergegeben werden. In dem gezeigten Ausführungsbeispiel ist eine erste Servervorrichtung 18 für die Messdaten 58 vorgesehen, die von der Aufzeichnungseinrichtung 16 erfasst werden, dort können auch erfasste Metadaten 62 abgelegt werden. Hiervon getrennt können in einer weiteren, z.B. einer internetbasierten zweiten Servervorrichtung 18 die gewonnen Lademodelle 60aus der Modellierungseinrichtung 30 abgelegt werden. Auf die Darstellung weiterer Einrichtungen, die sinnvoll ergänzbar wäre, wie z.B. eine Netzwerkverbindungseinrichtung 26 wird hier verzichtet.

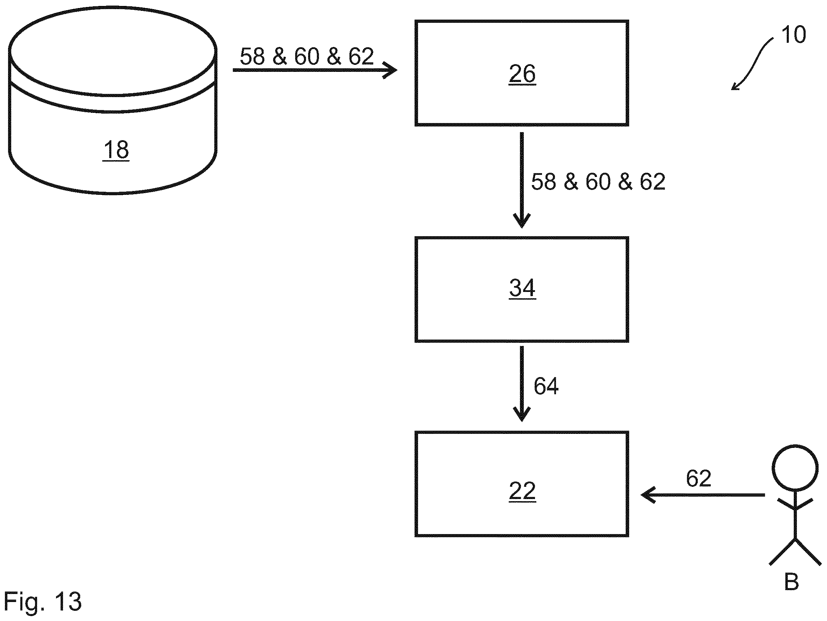

Die auf der Servervorrichtung 18 abgespeicherten Messdaten 58 und/oder Lademodelle 60 sowie Metadaten 62 können gemäß Fig. 13 durch eine Netzwerkverbindungseinrichtung 26 einer Emulationsvorrichtung 32 aus der Servervorrichtung 18 heruntergeladen werden. Ein Anwender B kann über eine Schnittstelleneinrichtung 22 an die Emulationseinrichtung 34 ein zu prüfendes Objekts bzw. ein Elektrofahrzeug 50 oder eine Ladestation 52 anschließen, in der Regel erfolgt dies durch eine entsprechen Ladestecker oder Ladebuchse. Durch die Emulationseinrichtung 34 können Emulationsdaten 64, die elektrische Verhaltensweisen, Protokollparameter und Kommunikationsinhalte umfassen und die durch das Lademodell 60 oder durch Abspielen von Messdaten 58 unter Berücksichtigung von durch Metadaten 62 definierte spezifische Randbedingungen emuliert werden. Dies erfolgt auf elektrischer Ebene über die Schnittstelleneinrichtung 22 Der Einsatz von Lademodellen 60 ist zu bevorzugten, da weitaus kleiner Datenmengen notwendig und selbst abweichendes Ladeverhalten emulierbar ist.

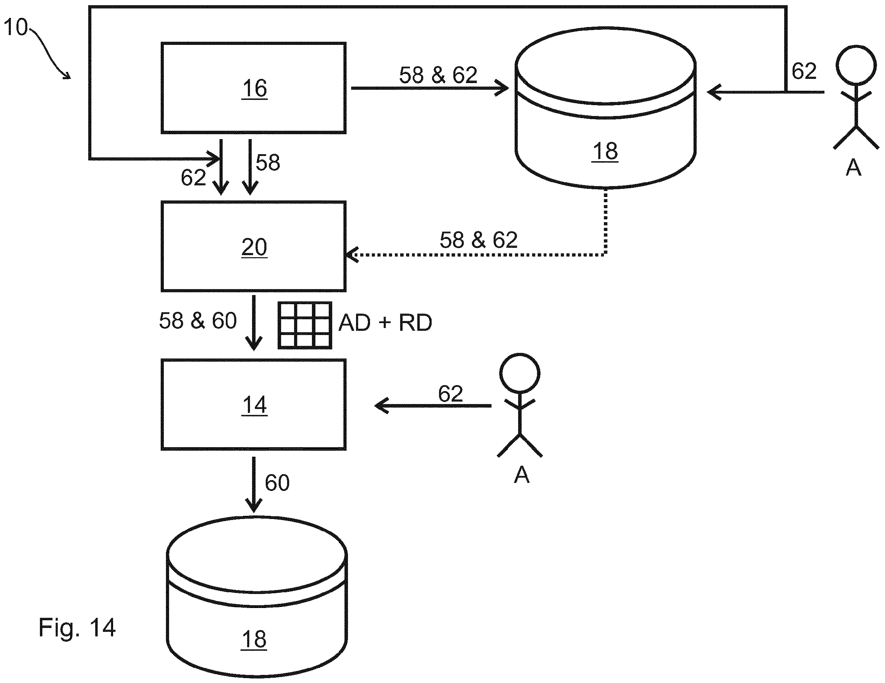

In einem weiteren, in Fig. 14 dargestellten, Ausführungsbeispiel eines Elektromobilitäts-Ladetestsystems 10 sind eine Aufzeichnungseinrichtung 16 einer Messvorrichtung 12, eine Aufteilungsvorrichtung 20, eine Modellierungsvorrichtung 14 und eine erste Servervorrichtung 18 umfasst. Ein Anwender A kann Metadaten 62 des Elektrofahrzeugs 50 und / oder der Ladestation 52 auf die Servervorrichtung 18 hochladen und mit Messdaten 58 der Aufzeichnungseinrichtung 16 kombiniert der Aufteilungsvorrichtung 20 zuführen. Durch die Aufzeichnungseinrichtung 16 kann ein Ladevorgang des Elektrofahrzeugs 50 und / oder der Ladestation 52 mittels der Messdaten 58 aufgezeichnet und protokolliert sowie Metadaten 62 automatisiert ermittelt werden. Die Messdaten 58 und Metadaten 62 werden zur Aufteilungsvorrichtung 20 übertragen und in der Servervorrichtung 18 gespeichert. Alternativ können die Messdaten 58, die von anderen Anwendern auf die Servervorrichtung 18 hochgeladen werden, aus der Servervorrichtung 18 direkt in die Aufteilungsvorrichtung 20 heruntergeladen werden. Dort werden die Messdaten 58 unter Berücksichtigung der Metadaten 62 nach Aktionsdaten AD und Reaktionsdaten RD des Testobjekts aufgeteilt. Die aufgeteilten Messdaten 58 AD und RD können weiter zur Modellierungsvorrichtung 14 übermittelt und hieraus ein Lademodell 60des Ladeverhaltens des Testobjektes generiert werden. Das Lademodell 60kann auf eine weitere, zweite Servervorrichtung 18 für Lademodelle 60 hochgeladen und zuvor ggf. durch weiter Metadaten 62 ergänzt werden. Die erste und zweite Servervorrichtung 18 können identisch sein, oder eine geräteinterne erste und eine internetbasierte zweite cloudbasierte-Servervorrichtung 18 sein.

Sobald ein zu prüfendes Objekt an das Elektrofahrzeug 50 und / oder die Ladestation 52 angeschlossen ist, können die Aktionsdaten AD gemäß der Aktion des zu prüfenden Testobjekts geprüft werden. Damit kann festgelegt werden, ob hierzu eine gleiche oder gegebenenfalls ähnliche Aktion durchgeführt werden kann. Dann können die an die Aktion des zu prüfenden Objekts anpassenden Reaktionsdaten RD ausgewählt und die entsprechende Reaktion des Elektrofahrzeugs und / oder der Ladestation abgespielt werden. Wird keine gleiche oder ähnliche Aktion gefunden, kann eine vordefinierte Standard-Reaktion erfolgen.

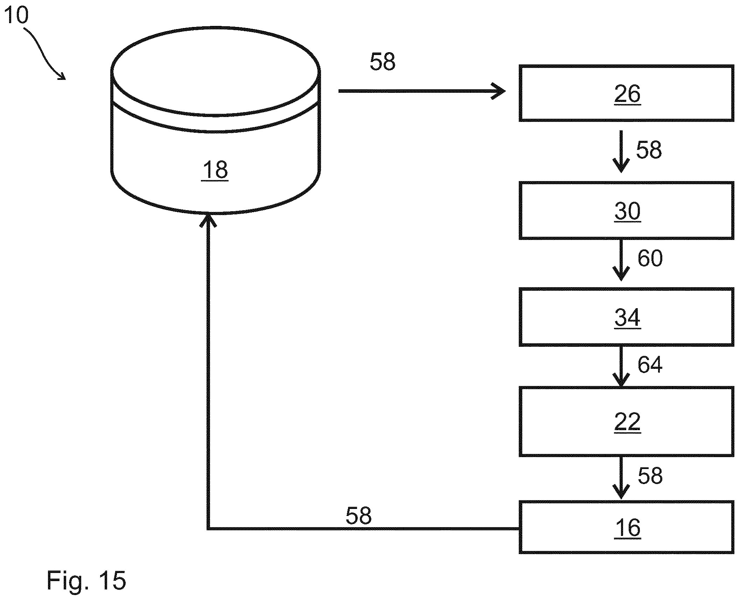

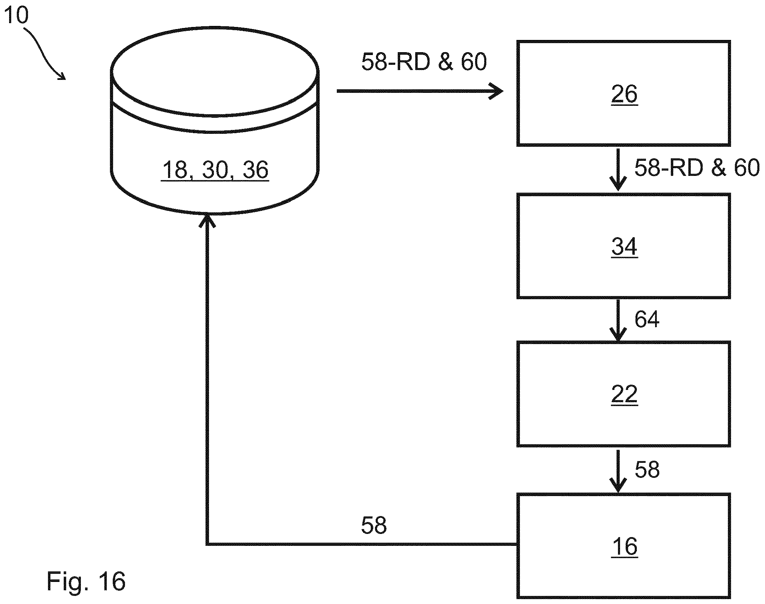

In den Figs. 15 und 16 sind weitere Ausführungsformen eines Elektromobilitäts-Ladetestsystems 10 schematisch dargestellt, die mit dem Elektromobilitäts-Ladetestsystem 10 in Fig. 14 zusammenarbeiten können. Nach Fig. 15 können Messdaten 58, nach Fig. 16 Lademodelle 60 und/oder Messdaten 58, insbesondere Reaktionsdaten von der Servervorrichtung 18 über eine Netzwerkverbindungseinrichtung 26 zu einer Emulationseinrichtung 34 einer Emulationsvorrichtung 32 übertragen werden, über die die entsprechenden Aktionen bzw. Reaktionen durch die Schnittstelleneinrichtung 22 an das Testobjekt übermittelt werden. Während nach der Ausführung in der Fig. 15 die Messdaten 58 zunächst über eine Modellierungseinrichtung 30 in ein Lademodell 60 umgewandelt werden, kann nach der Ausführungsform der Fig. 16 ein unmittelbares Abspielen der Reaktionsdaten RD der Messdaten 58 oder alternativ eine Emulation des Lademodells 60 durch die Emulationsvorrichtung 34 erfolgen. Die Emulationsvorrichtung 34 erzeugt Emulationsdaten 64, die über die Schnittstelleneinrichtung 22 an das angeschlossene Elektrofahrzeug 50 bzw. Ladesäule 52 ausgegeben werden. Mit einer Aufzeichnungseinrichtung 16 einer Messvorrichtung 12 können Messdaten 58 des zu prüfenden Objekts protokolliert werden, und wiederum in der Servervorrichtung 18 abgelegt werden. In der Servervorrichtung 18 kann weiterhin eine Aufteilungseinrichtung 36 zur Aufteilung der Messdaten 58 in Aktions- und Reaktionsdaten AD, RD und eine Modellierungseinrichtung 30 zur zentralen Erstellung eines Lademodells 60 vorgesehen sein. Somit kann das Aktions- bzw. Reaktionsverhaltens des Ladevorgangs eines Testobjektes durch Abspielen von Aktions- oder Reaktionsdaten und Aufnahme der jeweiligen Aktion bzw. Reaktionen analysiert werden. Die Aktions- oder Reaktionsdaten können auf Messdaten 58 beruhen, oder aus Lademodellen 60 gewonnen werden.

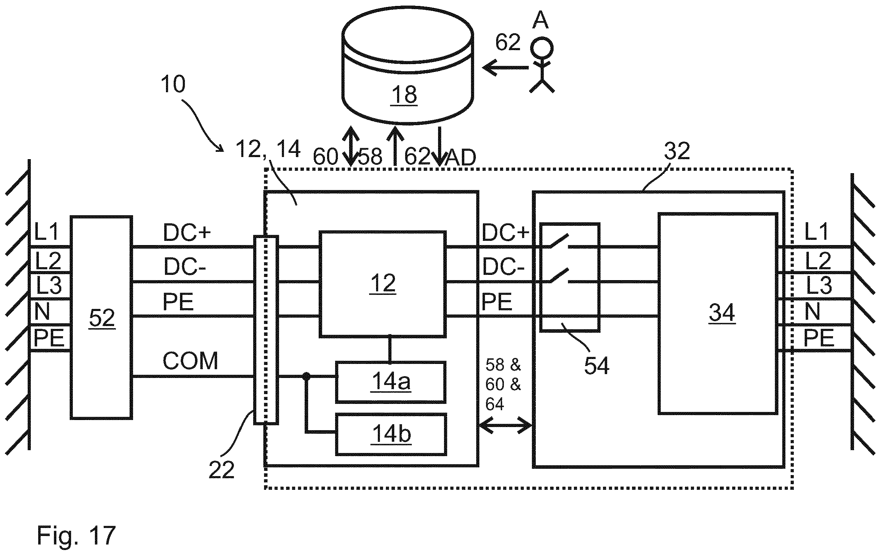

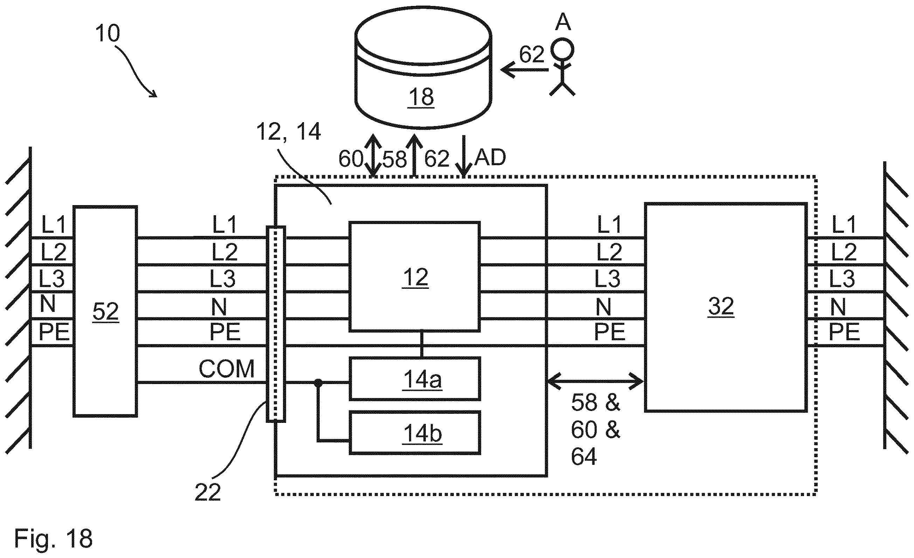

In den Figs. 17 und 18 sind Beispielformen von Elektromobilitäts-Ladetestsystemen 10 dargestellt, die insbesondere zur Analyse von Ladesäulen 52 eingerichtet sind.

In Fig. 17 ist eine weitere Beispielform eines Elektromobilitäts-Ladetestsystems 10 zum Prüfen von Ladevorgängen einer DC-Emulationsvorrichtung 32 bzw. eines DC-Elektrofahrzeugs 50 und einer DC-Ladestation 52 mit Veranschaulichung der Leistungsverbindungen dargestellt. Die DC-Emulationsvorrichtung 32 wird zum Emulieren eines auswählbaren DC-Elektrofahrzeugs 50 eingesetzt. Durch die Auswahl eines, einem Elektrofahrzeug-Typ entsprechenden Lademodells 60 oder Messdaten 58 kann die Interoperabilität dieses Typs mit der Ladesäule 52 getestet werden. Mittels der DC-Ladestation 52 wird hierzu ein Netz-Drehstrom L1, L2, L3, N, PE in eine Gleichspannung umgewandelt, wobei die DC-Ladestation 52 über eine Schnittstelleneinrichtung 22 mit entsprechendem Ladestecker an eine Messvorrichtung 12 bzw. Modellierungsvorrichtung 14 angeschlossen wird. Die Modellierungsvorrichtung 14 umfasst zwei Modellierungseinrichtungen 14a, 14b, die zur Generierung von Lademodellen 60 der Strom/Spannungsmessung der Leistungsverbindung DC+, DC- und von Protokollinformation und Metadaten 62 der Datensignale COM, die als Messdaten 58 bezeichnet werden, ausgelegt sind. Die generierten Lademodelle 60 können über eine nicht dargestellte Netzwerkverbindungseinrichtung auf eine Servervorrichtung 18, beispielsweise einen Internetserver hochgeladen bzw. heruntergeladen werden. Durch eine Schaltvorrichtung 54 der DC-Emulationsvorrichtung 32 kann die Messvorrichtung 12 und Modellierungsvorrichtung 14 elektrisch von der Emulationseinrichtung 34 getrennt werden. Die Emulationseinrichtung 34 emuliert auf Basis des Lademodells 60 oder von abspielbaren Messdaten 58 das Ladeverhalten eines vorausgewählten Elektrofahrzeugs 50 und gibt hierzu Emulationsdaten 64 als Strom.-/Spannungswerte ab bzw. nimmt diese auf, und kann ggf. auch Datensignale ausgeben. In diesem Ausführungsbeispiel werden die Datensignale COM von der Modellierungseinrichtung 14a ausgegeben. Damit können Ladevorgänge der DC-Emulationsvorrichtung 32, insbesondere des DC-Elektrofahrzeugs 50, und die DC-Ladestation 52 gemessen, aufgezeichnet und in ein Lademodell abgebildet werden. Weiterhin kann ein Anwender A Metadaten 62 des DC-Elektrofahrzeugs 50 und / oder der DC-Ladestation 52 auf die Servervorrichtung 18 manuell oder halbautomatisch hochladen, um den Ladevorgang näher zu spezifizieren. Weiterhin können elektrisch erfassbare Metadaten 62 der Ladesäule 52 automatisch über die Messvorrichtung 12 erfasst und hochgeladen werden.

Im Vergleich zu Fig. 17 stellt Fig. 18 eine weitere Beispielform eines Elektromobilitäts-Ladetestsystems 10 zum Prüfen von Ladevorgängen einer AC-Emulationsvorrichtung 32 bzw. eines AC-Elektrofahrzeugs 50 und einer AC-Ladestation 52 dar. Im Wesentlichen ist dies mit dem Aufbau des Ausführungsbeispiels nach Fig. 17 identisch, wobei ein Ladevorgang auf Wechsel- bzw. Drehstrombasis erfolgt, und entsprechende Gleichrichter im durch das Ladetestsystem 10 emulierten Elektrofahrzeug 50 vorgesehen sind. Weiterhin unterscheidet sich dieses Beispiel zum in Fig. 17 gezeigten Ausführungsbeispiel dadurch, dass die AC-Emulationsvorrichtung 32 bzw. das AC-Elektrofahrzeug 50 unmittelbar ohne Anordnung einer Schaltvorrichtung 54 an die Messvorrichtung 12 und Modellierungsvorrichtung 14 angeschlossen ist.

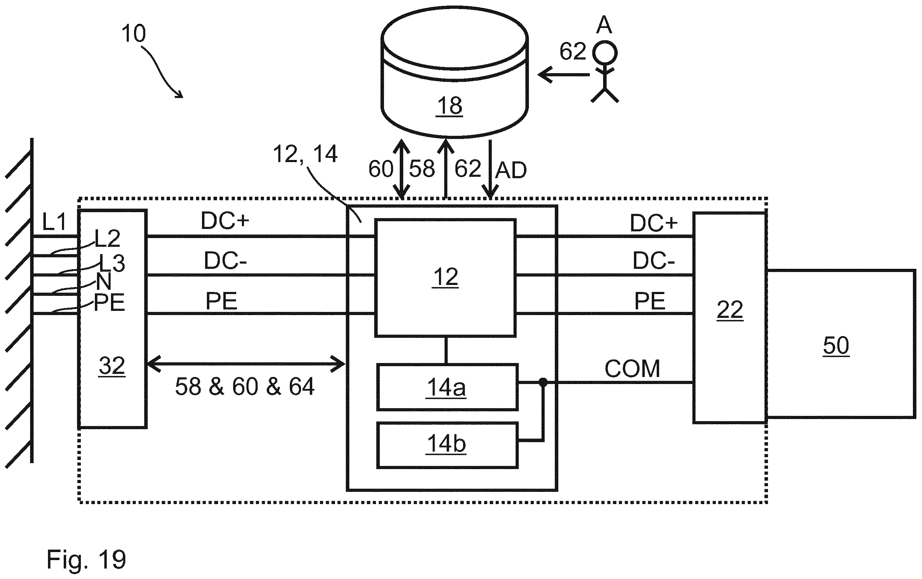

In den Figs. 19 bis 21 sind weitere Beispielformen von Elektromobilitäts-Ladetestsystemen 10 dargestellt, die insbesondere zur Analyse eines Elektrofahrzeugs 50 eingerichtet sind.

Fig. 19 zeigt eine Ausführungsform eines Elektromobilitäts-Ladetestsystems 10 zum Emulieren einer auswählbaren DC-Ladestation 52 oder des Anschlusses eines Versorgungsnetzes an ein zu testendes DC-Elektrofahrzeug 50. Hierdurch kann die Interoperabilität des Elektrofahrzeugs 50 mit einer Mehrzahl von Typen von Ladesäulen 52 getestet werden. Der wesentliche Aufbau dieses Beispiels ist im Wesentlichen mit dem Aufbau des Beispiels nach Fig. 17 identisch. Nach der in Fig. 19 dargestellten Beispielform ist das Elektrofahrzeug 50 über eine in einer Steckverbindung integrierten Schnittstelleneinrichtung 22 mit einer Messvorrichtung 12 und Modellierungsvorrichtung 14 elektrisch verbunden. Im Unterschied zum Beispiel in Fig. 17 wird eine DC-Emulationsvorrichtung 32 zum Emulieren einer spezifizierbaren DC-Ladestation 52 eingesetzt, alternativ kann z.B. für die Messdatenerhebung eine DC-Ladestation 52 angeschlossen sein. Der Type der zu emulierenden Ladestation 52 kann über ein aus der Servervorrichtung 18 herunterladbares Lademodell 60 oder über abspielbare Messdaten 58 ausgewählt und die entsprechenden Energieströme DC+, DC- durch die Emulationsvorrichtung 32 bereitgestellt werden. Kommunikationsdaten COM können über die Modellierungseinrichtungen 14a, 14b aufgenommen und ausgegeben werden.

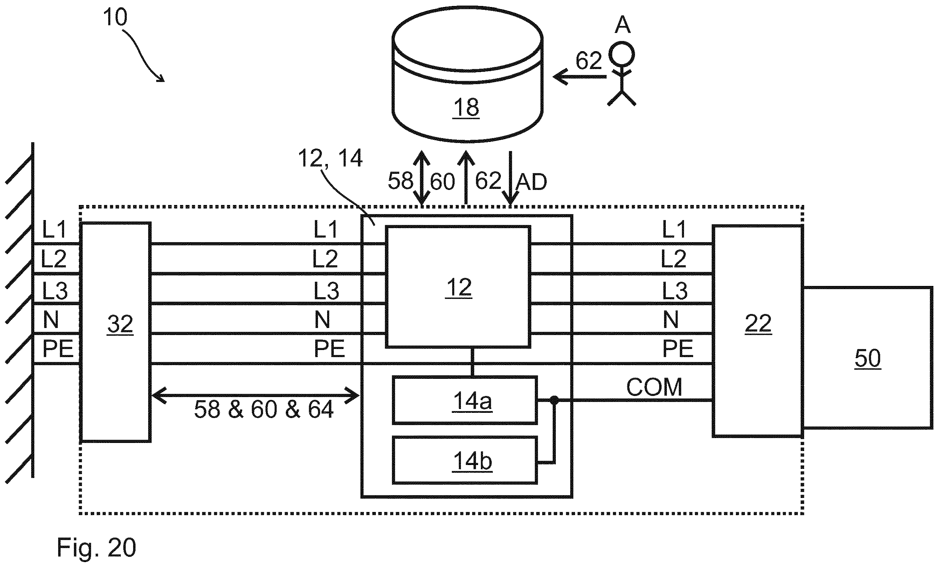

Im Vergleich zu Fig. 19 ist in Fig. 20 eine weitere Beispielform eines Elektromobilitäts-Ladetestsystems 10 zum Prüfen von Ladevorgängen einer AC-Emulationsvorrichtung 32 bzw. einer AC-Ladestation 52 und eines AC-Elektrofahrzeugs 50 dargestellt. Aufbau und Funktion dieser Beispielform ist ansonsten identisch mit dem DC-Aufbau der Ausführungsform in Fig. 19.

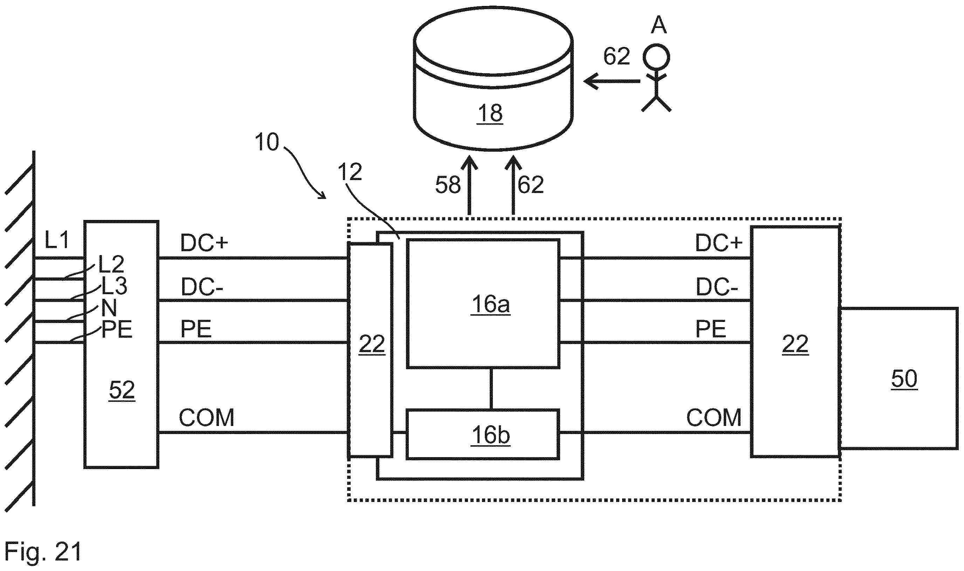

In Fig. 21 ist eine weitere Beispielform eines DC-Elektromobilitäts-Ladetestsystems 10 zum Prüfen von Ladevorgängen einer DC-Ladestation 52 und eines DC-Elektrofahrzeugs 50 gezeigt. Diese Beispielform ist besonders zur Aufnahme von Messdaten 58, Metadaten 62 und zur Generierung von Lademodellen 60 von Ladesäulen 52 und Elektrofahrzeugen 50 geeignet. Zum Messen von Ladevorgängen zwischen DC-Ladestation 52 und DC-Elektrofahrzeug 50 ist eine Messvorrichtung 12 im Ladekabel angeordnet, wobei die Messvorrichtung 12 zwei Aufzeichnungseinheiten 16a, 16b umfasst. Die von der Aufzeichnungseinheit 16a zur Messung der Leistungsströme und der Aufzeichnungseinheit 16b zur Messung von Kommunikationsdaten COM protokollierten Messdaten 58 und ggf. generierten Metadaten 62 werden durch Hochladen auf einer Servervorrichtung 18 abgespeichert. Ein Anwender A kann Metadaten 62 des DC-Elektrofahrzeugs 50 und DC-Ladestation 52 manuell oder halbautomatisch, z.B. durch Scannen eines Barcodes oder QR-Codes, die das Fahrzeug 50 oder die Ladesäule 52 charakterisieren, ebenfalls in die Servervorrichtung 18 hochladen. Zur Ankopplung an die Ladesäule 52 und an das Elektrofahrzeug 50 ist jeweils eine Schnittstelleneinrichtung 22 vorgesehen.

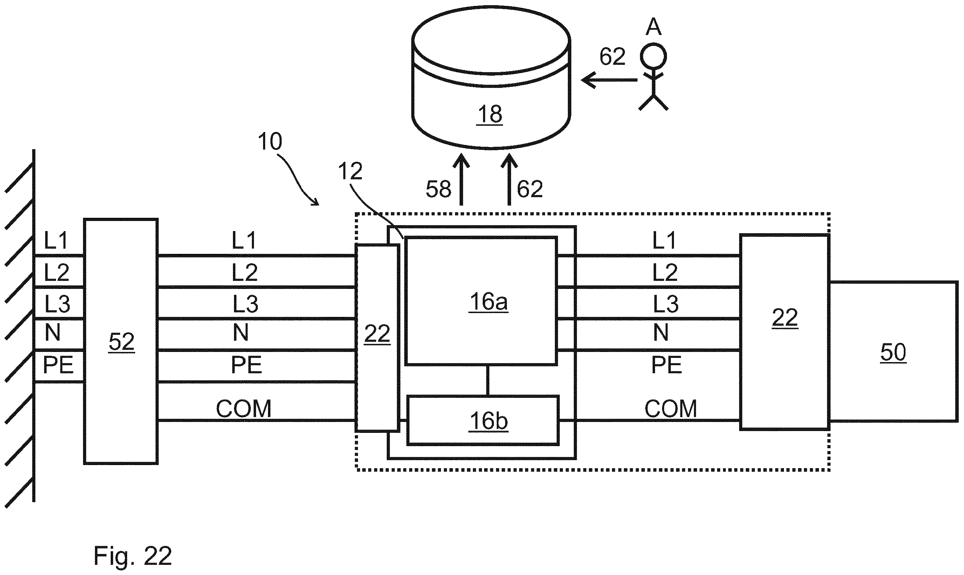

Im Vergleich zu Fig. 21 ist in Fig. 22 eine weitere Beispielform eines Elektromobilitäts-Ladetestsystems 10 zum Prüfen von Wechselstrom-Ladevorgängen einer AC-Ladestation 52 und eines AC-Elektrofahrzeugs 50 auf Drehstrombasis dargestellt, wobei der weitere Aufbau des Elektromobilitäts-Ladetestsystems 10 identisch mit dem Aufbau des DC-Ausführungsbeispiels nach Fig. 21 ist.

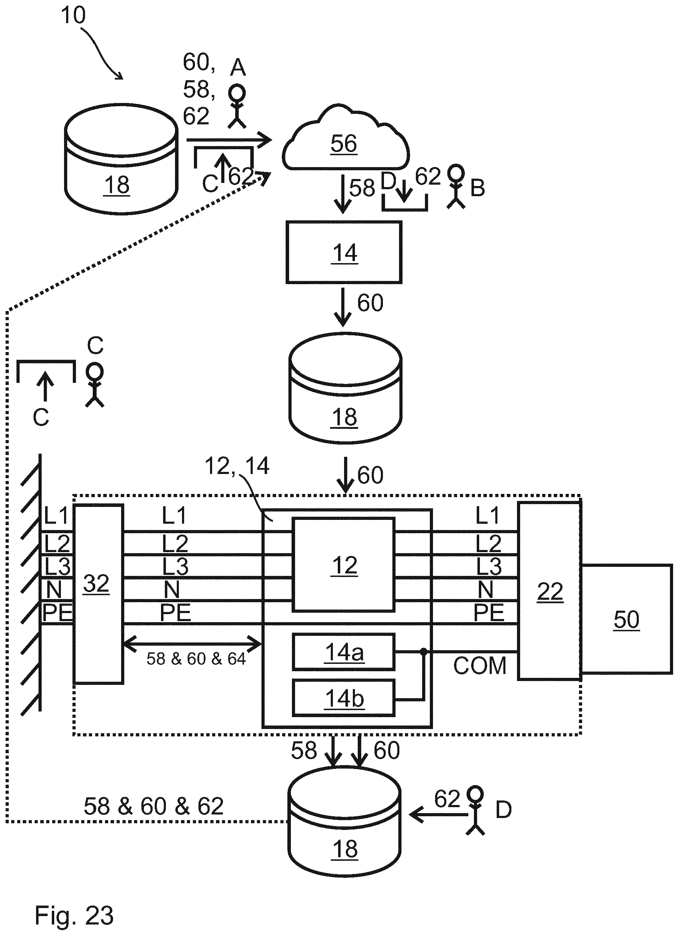

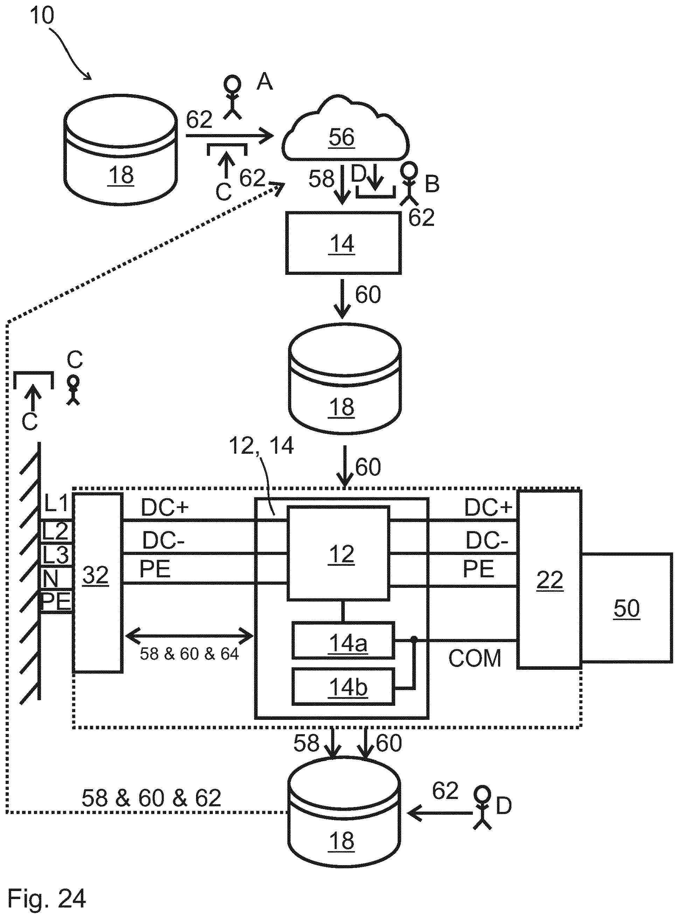

Die Figs. 23 und 24 zeigen zwei Beispielformen für ein Testen eines AC- bzw.

DC-Ladevorgangs eines spezifischen Elektrofahrzeugs 50, bei dem das Ladetestsystem eine auswählbare Ladesäule 52 emuliert.

Nach Fig. 23 kann in einer Beispielform eines AC- Ladetestsystems 10 ein Anwender A Messdaten 58 und / oder ein Lademodell 60 von Ladevorgängen eines Elektrofahrzeugs, die zuvor von dem Anwender C geprüft wurde, sowie Metadaten 62 auf eine als Servervorrichtung 18 ausgebildete Online-Austauschplattform 56 hochladen. Die auf der Online-Austauschplattform 56 abgespeicherten Daten von Lademodellen 60 oder Messdaten 58 können von einem Anwender B heruntergeladen werden. Werden Messdaten 58 heruntergeladen, kann durch eine externe, beispielsweise in der Online-Austauschplattform 56 angeordnete Modellierungsvorrichtung 14 hieraus optional ein Lademodell 60 erstellt werden. Des Weiteren können neben der Messvorrichtung 12 auch Modellierungseinrichtungen 14a, 14b in der Testvorrichtung 10 vorgesehen sein, die auf Basis der während des Emulationsvorgangs aufgenommen Messdaten 58 und Metadaten 62 ein Lademodell 60 des zu prüfenden Elektrofahrzeugs 50 erstellen können. Somit können die beiden Modellierungseinrichtungen 14a, 14b der, Modellierungsvorrichtung 14 ein Lademodell 60 generiert werden. Das erzeugte Lademodell und / oder die Messdaten 58, ggf. auch generierte Metadaten 62 können lokal auf einer Servervorrichtung 18 abgelegt werden. Diese können durch einen Anwender D, ggf. unterfüttert mit weiteren Metadaten 62 in die Online-Austauschplattform 56 hochgeladen werden. Die auf der Servervorrichtung 18 der Online-Austauschplattform 56 gespeicherten Lademodelle 60, Messdaten 58 und Metadaten 62 können zentral von eine Anwender A geprüft und mit weiteren Metadaten 62 ergänzt werden.

Ein auf der Servervorrichtung 18 abgespeichertes Lademodell 60 oder abspielbare Messdaten 58 können von dem Anwender B zum Emulieren einer spezifizierbaren AC-Ladestation 52, die als AC-Emulationsvorrichtung 32 ausgebildet ist, ausgewählt werden, um die Interoperabilität einer Vielzahl von Ladesäulentypen 52 mit dem angeschlossenen AC-Elektrofahrzeugs 50 testen zu können. Die AC-Emulationsvorrichtung 32 ist unmittelbar und das AC-Elektrofahrzeug 50 ist über eine Schnittstelleneinrichtung 22 an die Messvorrichtung 12 und Modellierungsvorrichtung 14 angeschlossen. Mittels der Messvorrichtung 12 und Modellierungsvorrichtung 14 lassen sich sowohl Lademodell 60der Ladevorgänge mit den Messdaten aufbauen als auch anspielbare Messdaten 58 erfassen. Die Messdaten 58 und das Lademodell 60 des und der von dem Anwender D zu prüfenden Elektrofahrzeugs 50, 52 sowie weitere Metadaten 62 können von dem Anwender C auf eine Servervorrichtung 18 hochgeladen werden.

Im Wesentlichen ist die Beispielform nach Fig. 24 mit dem Aufbau des Ausführungsbeispiels nach Fig. 23 vergleichbar. Allerdings unterscheidet sich dieses Ausführungsbeispiel zum in Fig. 23 dargestellten DC-Ausführungsbeispiel dadurch, dass anstelle der AC-Emulationsvorrichtung 32 bzw. der AC-Ladestation 52 und des AC-Elektrofahrzeugs 50 eine DC-Emulationsvorrichtung 32 bzw. eine DC-Ladestation 52 und ein DC-Elektrofahrzeugs 50 von dem Anwender D genutzt werden.

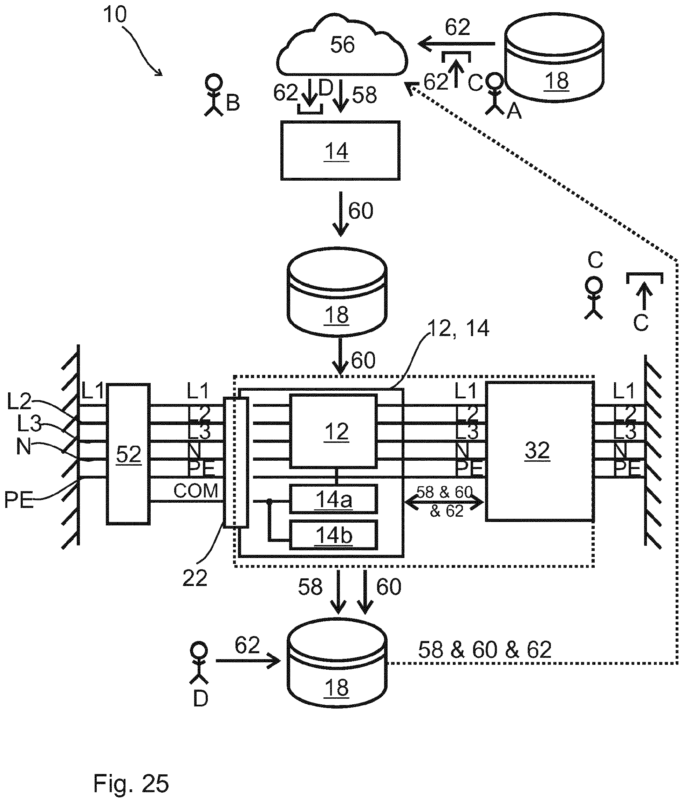

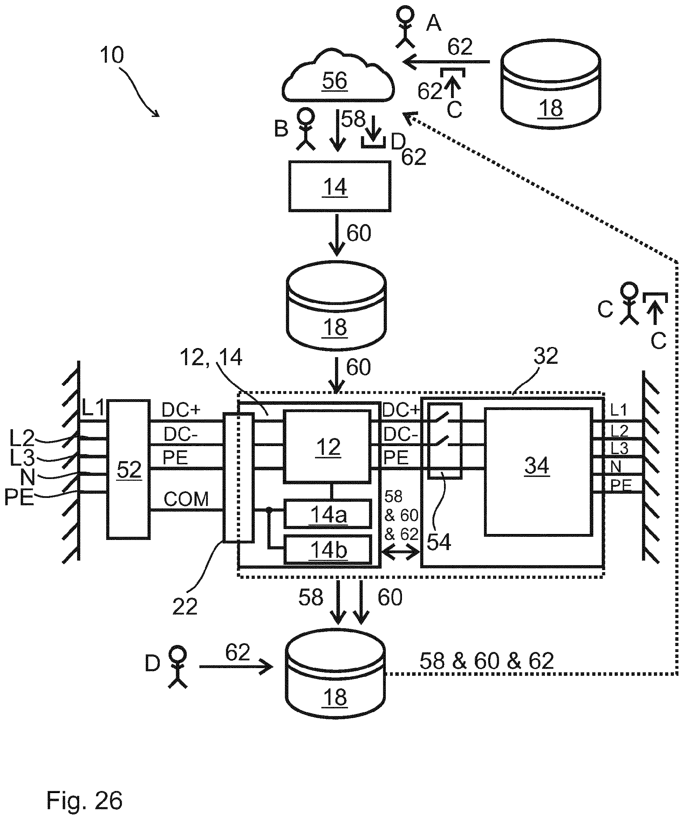

Die Ausführungsformen eines Ladetestsystems 10 nach Fig. 25 und Fig. 26 sind im Wesentlichen identisch mit den Beispielformen nach Fig. 23 und 24, dienen allerdings nicht zum Testen eines Elektrofahrzeugs 50 sondern einer konkreten Ladesäule 52.

Hierzu zeigt Fig. 25 einen AC-Ladevorgang und Fig. 26 einen DC-Ladevorgang.

Im Vergleich zur in Fig. 23 dargestellten Beispielform ist in Fig. 25 die AC-Ladestation 52 über eine Schnittstelleneinrichtung 22 an die Messvorrichtung 12 und Modellierungsvorrichtung 14 angeschlossen, während ein auswählbares Elektrofahrzeug 50 durch die Emulationsvorrichtung 32 emuliert wird.

Dagegen unterscheidet sich die in Fig. 26 gezeigte Beispielform zur in Fig. 24 dargestellten Ausführungsform dadurch, dass die DC-Ladestation 52 über eine Schnittstelleneinrichtung 22 an die Messvorrichtung 12 und Modellierungsvorrichtung 14 angeschlossen ist. Ein durch Messdaten 58 bzw. Lademodell 60 auswählbares DC-Elektrofahrzeug 50 wird durch eine, eine Schaltvorrichtung 54 umfassende DC-Emulationsvorrichtung 32 emuliert.

### Bezugszeichenliste

- 10: Elektromobilitäts-Ladetestsystem
- 12: Messvorrichtung
- 14: Modellierungsvorrichtung
- 14a, 14b: Modellierungseinrichtung
- 16: Aufzeichnungseinrichtung
- 16a, 16b: Aufzeichnungseinheit
- 18: Servervorrichtung / Datenbank / Datenspeicher
- 20: Aufteilungsvorrichtung
- 22: Schnittstelleneinrichtung
- 24: Speichereinrichtung
- 26: Netzwerkverbindungseinrichtung / Datenschnittstelle
- 28: Aufbereitungseinrichtung
- 30: Modellierungseinrichtung
- 32: Emulationsvorrichtung, DC-Emulationsvorrichtung
- 34: Emulationseinrichtung
- 36: Aufteilungseinrichtung
- 38: Auswahleinrichtung
- 40: Messvorgang
- 42: Emulationsvorgang
- 44: Modellierungsvorgang
- 46: Aufteilungsvorgang
- 48: Zugriffskontrolleinrichtung
- 50: Elektrofahrzeug, DC-Elektrofahrzeug, AC-Elektrofahrzeug
- 52: Ladestation, DC-Ladestation, AC-Ladestation
- 54: Schaltvorrichtung
- 56: Online-Austauschplattform
- 58: Messdaten

- 60: Lademodell
- 62: Metadaten
- 64: Emulationsdaten
- 66: Analyseeinrichtung
- 68: Simulationseinrichtung

- COM: Kommunikationsdaten
- AD: Aktionsdaten
- RD: Reaktionsdaten
- A: Anwender A
- B: Anwender B
- T1: Typ 1
- T2: Typ 2
- T3: Typ 3

- C: Hochladen
- D: Herunterladen

## Patentansprüche

1. Elektromobilitäts-Ladetestsystem (10) zum Generieren und Austausch von Messdaten (58) oder eines Lademodells (60) von elektrischen Verhaltensweisen, insbesondere Spannungs- und / oder Stromverhalten, Protokollparametern und Kommunikationsinhalten eines Ladevorgangs eines Elektrofahrzeugs (50) und / oder einer Ladestation (52), wobei der Ladevorgang aus einer Aktion des Elektrofahrzeugs (50) und einer Reaktion der Ladestation (52) besteht, sowie zum Prüfen der Kommunikationsfähigkeit und/oder Ladefähigkeit des Elektrofahrzeugs (50) und / oder der Ladestation (52) umfassend zumindest eine Messvorrichtung (12) zur Bereitstellung der Messdaten (58) der elektrischen Verhaltensweisen, Protokollparameter und/oder Kommunikationsinhalte des Ladevorgangs des Elektrofahrzeugs (50) und / oder der Ladestation (52), wobei das Elektromobilitäts-Ladetestsystem (10) ferner umfasst:
- zumindest eine Modellierungsvorrichtung (14) zur Erstellung eines Lademodells (60) des Ladevorgangs, eingerichtet um basierend auf die von der Messvorrichtung (12) erfassten Messdaten (58) das Lademodell (60) für Aktion und Reaktion automatisiert zu generieren, wodurch Lademodelle (60) generierbar sind,
- zumindest eine Servervorrichtung (18) zum Abspeichern und zur Bereitstellung einer Austauschmöglichkeit der Messdaten (58) oder des Lademodells (60), so dass die Messdaten (58) oder das Lademodell (60) direkt oder über ein Netzwerk auf die Servervorrichtung (18) hochladbar und / oder von der Servervorrichtung (18) herunterladbar sind,
**dadurch gekennzeichnet, dass** die Lademodelle (60) elektrofahrzeugseitig oder ladestationsseitig generierbar sind; dass das Elektromobilitäts-Ladetestsystem (10) eingerichtet ist, die Messdaten in Aktionsdaten, die gemäß der Aktion des Elektrofahrzeugs (50) beim Ladevorgang erfassbar sind, und in an die Aktion anpassende Reaktionsdaten der Ladestation (52) aufzuteilen, und dass das Elektromobilitäts-Ladetestsystem (10) ferner umfasst:
- zumindest eine Emulationsvorrichtung (32) zum Herunterladen der Messdaten (58) und des Lademodells (60) von der Messvorrichtung (12), oder der Modellierungsvorrichtung (14), oder der Servervorrichtung (18) und zum Emulieren der Aktion des Ladevorgangs des Elektrofahrzeugs (50) und der Reaktion des Ladevorgangs der Ladestation (52) durch Abspielen der in Aktions- und Reaktionsdaten aufgeteilten Messdaten (58) und des entsprechend generierten Lademodells (60).

2. Elektromobilitäts-Ladetestsystem (10) nach Anspruch 1, **dadurch gekennzeichnet, dass** die Messvorrichtung (12) eine Schnittstelleneinrichtung (22) zur Verbindung an ein Elektrofahrzeug (50) und/oder einer Ladestation (52), eine Aufzeichnungseinrichtung (16) und eine Netzwerkverbindungseinrichtung (26) umfasst, wobei die Messdaten (58) über die Schnittstelleneinrichtung (22) mittels der Aufzeichnungseinrichtung (16) protokollierbar sind, und durch die Netzwerkverbindungseinrichtung (26) auf die Servervorrichtung (18) hochladbar und/oder zur Modellierungsvorrichtung (14) übertragbar sind.

3. Elektromobilitäts-Ladetestsystem (10) nach Anspruch 2, **dadurch gekennzeichnet, dass** die Netzwerkverbindungseinrichtung (26) als eine kabelgebundene Datenschnittstelle, insbesondere eine CAN-Schnittstelle, Ethernet, LIN, RS232, GPIB, SPI, I2C, MOST-Bus, FlexRay, Profibus, CANopen, SERCOS, oder als eine drahtlose Netzwerkverbindungseinrichtung, insbesondere eine LAN, Mobilfunk-, WLAN- oder NFC/RFID-Netzwerkverbindungseinrichtung, ausgebildet ist, so dass die Messdaten (58) über die Netzwerkverbindungseinrichtung (26) innerhalb des Elektromobilitäts-Ladetestsystems (10) und/oder auf die Servervorrichtung (18) und/oder zur Modellierungsvorrichtung (14) übertragbar sind.

4. Elektromobilitäts-Ladetestsystem (10) nach einem der vorangegangenen Ansprüche, **dadurch gekennzeichnet, dass** in der Modellierungsvorrichtung (14) zumindest eine Netzwerkverbindungseinrichtung (26), bevorzugt eine drahtlosem Netzwerkverbindungseinrichtung, insbesondere eine Funk-, WLAN- oder NFC-Netzwerkverbindungseinrichtung, zum Auslesen der Messdaten (58) aus der Messvorrichtung (12) und/oder aus der Servervorrichtung (18), zumindest eine Modellierungseinrichtung (30) zur Modellierung der Messdaten (58) des Ladevorgangs, insbesondere zwei Modellierungseinrichtungen (30) für die Modellierung der Messdaten des Elektrofahrzeugs (50) und/oder der Ladestation (52), zumindest eine Aufbereitungseinrichtung (28) zur Verarbeitung der Messdaten (58) zu einem an das Lademodell (60) angepassten Datenformat und zumindest eine Netzwerkverbindungseinrichtung (26) zum Hochladen des Lademodells (60) auf die Servervorrichtung (18) und/oder Herunterladen von Messdaten (58) aus der Servervorrichtung (18) und/oder zur Übermittlung zur Emulationsvorrichtung (32) umfasst sind.

5. Elektromobilitäts-Ladetestsystem (10) nach Anspruch 4, **dadurch gekennzeichnet, dass** eine Aufteilungsvorrichtung (20) umfasst ist, die eingerichtet ist, Messdaten (58) nach einer vordefinierten Verhaltensweise des Elektrofahrzeugs (50) und / oder der Ladestation (52) aufzuteilen, insbesondere in Aktions- und Reaktionsdaten aufzuteilen.

6. Elektromobilitäts-Ladetestsystem (10) nach Anspruch 5, **dadurch gekennzeichnet, dass** die Aufteilungsvorrichtung (20) zumindest eine Netzwerkverbindungseinrichtung (26) zum Auslesen und/oder Übergeben bzw. Herunterladen und/oder Hinaufladen der Messdaten (58) aus der Messvorrichtung (12) und / oder Modellierungsvorrichtung (14), und / oder der Servervorrichtung (18), und zumindest eine Aufteilungseinrichtung (36) zur Durchführung einer vordefinierbaren Datenaufteilung umfasst.

7. Elektromobilitäts-Ladetestsystem (10) nach Anspruch 5 oder 6, **dadurch gekennzeichnet, dass** die Aufteilungseinrichtung (36) in die Modellierungsvorrichtung (14) umfasst ist, um Aktions- und Reaktionsdaten (AD, RD) unterschieden verwerten zu können.

8. Elektromobilitäts-Ladetestsystem (10) nach Anspruch 4, **dadurch gekennzeichnet, dass** in der Modellierungsvorrichtung (14) zumindest eine Analyseeinrichtung (66) und / oder eine Simulationseinrichtung (68) umfasst sind, wobei die Analyse- und / oder die Simulationseinrichtung (66, 68) eingerichtet ist, die in Aktions- und Reaktionsdaten aufgeteilten Messdaten (58) zu analysieren und die elektrischen Verhaltensweisen, Protokollparameter und Kommunikationsinhalte des Ladevorgangs des Elektrofahrzeugs (50) und / oder der Ladestation (52) zu simulieren.

9. Elektromobilitäts-Ladetestsystem (10) nach einem der vorgenannten Ansprüche, **dadurch gekennzeichnet, dass** die Emulationsvorrichtung (32) zumindest eine Netzwerkverbindungseinrichtung (26) zum Herunterladen der Messdaten (58) und / oder des Lademodells (60) und zumindest eine Emulationseinrichtung (34) umfasst, wobei durch die Emulationseinrichtung (34) die aufgezeichneten bzw. simulierten elektrischen Verhaltensweisen, Protokollparametern und Kommunikationsinhalten des Ladevorgangs des Elektrofahrzeugs (50) und / oder der Ladestation (52) nachahmbar bzw. emulierbar sind.

10. Elektromobilitäts-Ladetestsystem (10) nach den Anspruch 9, **dadurch gekennzeichnet, dass** die Emulationseinrichtung (34) eine Auswahleinrichtung (38) umfasst, die eingerichtet ist, die von der Servervorrichtung (18) heruntergeladenen Messdaten (58) und / oder des Lademodells (60) von der Auswahleinrichtung (38) aufzuteilen, insbesondere in Aktions- und Reaktionsdaten aufzuteilen, wodurch vor der Emulation eine angepasste elektrische Verhaltensweise, Protokollparameter und Kommunikationsinhalte für eine realitätsnahe Nachbildung des Elektrofahrzeugs (50) und / oder der Ladestation (52) manuell, automatisch oder halbautomatisch bereitstellbar sind.

11. Elektromobilitäts-Ladetestsystem (10) nach einem der vorherigen Ansprüche, **dadurch gekennzeichnet, dass** die Messvorrichtung (12) und die Modellierungsvorrichtung (14) baulich in einem Gehäuse umfasst sind.

12. Elektromobilitäts-Ladetestsystem (10) nach einem der vorherigen Ansprüche, **dadurch gekennzeichnet, dass** die Modellierungsvorrichtung (14) und die Emulationsvorrichtung (32) baulich in einem Gehäuse umfasst sind.

13. Elektromobilitäts-Ladetestsystem (10) nach einem der vorherigen Ansprüche, **dadurch gekennzeichnet, dass** die Servervorrichtung (18) zumindest teilweise als cloudbasierter Internetserver ausgeführt ist, wobei bevorzugt ein Zugriff auf die Servervorrichtung (18) durch eine Zugriffskontrolleinrichtung (48) kontrollierbar ist.

14. Elektromobilitäts-Ladetestsystem (10) nach einem der vorherigen Ansprüche, **dadurch gekennzeichnet, dass** die Modellierungsvorrichtung (14) in der Servervorrichtung (18) angeordnet ist.

15. Elektromobilitäts-Ladetestsystem (10) nach einem der vorherigen Ansprüche, **dadurch gekennzeichnet, dass** eine Aufteilungsvorrichtung (20) in der Servervorrichtung (18) angeordnet ist, die eingerichtet ist, die Messdaten (58) nach einer vordefinierten Verhaltensweise des Elektrofahrzeugs (50) und / oder der Ladestation (52) aufzuteilen, insbesondere in Aktions- und Reaktionsdaten aufzuteilen sind.

16. Elektromobilitäts-Ladetestsystem (10) nach einem der vorherigen Ansprüche, **dadurch gekennzeichnet, dass** die Messdaten (58) und / oder das Lademodell (60) Metadaten (62) über das Elektrofahrzeugs (50) und / oder die Ladestation (52) umfassen, die bei Messung zwischen der Ladestation (52) und dem Elektrofahrzeugs (50) durch die Messvorrichtung (12) erfasst werden, insbesondere Gerätehersteller, Gerätetyp, Herstellungsdatum, Seriennummer, Softwareversion, Aufzeichnungsdatum, Geräteabbildung, Typenschild, Gerätestandort, Batteriekapazität und / oder Batterie-Innenwiderstand, sowie Informationen zur Messvorrichtung (12) wie Gerätetyp, Firmware-Version, Gerätehersteller, Hardwareversion, und/oder Software-Umfang.

17. Elektromobilitäts-Ladetestverfahren zum Generieren und Austausch von Messdaten (58) oder eines Lademodells (60) von elektrischen Verhaltensweise, insbesondere Spannungs- und / oder Stromverhalten, Protokollparametern und Kommunikationsinhalten eines Ladevorgangs eines Elektrofahrzeugs (50) und / oder einer Ladestation (52), wobei der Ladevorgang aus einer Aktion des Elektrofahrzeugs (50) und einer Reaktion der Ladestation (52) besteht, sowie zum Prüfen der Kommunikationsfähigkeit des Elektrofahrzeugs und / oder der Ladestation, durch ein Elektromobilitäts-Ladetestsystem (10) nach einem der vorgenannten Ansprüche, umfassend den Schritt:
- Messen der elektrischen Verhaltensweisen, Protokollparameter und Kommunikationsinhalte des Ladevorgangs des Elektrofahrzeugs (50) und / oder der Ladestation (52) durch die Messvorrichtung (12),
**dadurch gekennzeichnet,**
**dass** die Messdaten (58) in Aktionsdaten, die gemäß der Aktion des Elektrofahrzeugs (50) beim Ladevorgang erfasst werden, und in an die Aktion anpassende Reaktionsdaten der Ladestation (52) aufgeteilt werden, und das Elektromobilitäts-Ladetestverfahren ferner die Schritte umfasst:
- Automatisiertes Generieren eines Lademodells (60) des Ladevorgangs für die Aktions- und Reaktionsdaten durch die Modellierungsvorrichtung (14) basierend auf den erfassten Messdaten (58), wodurch das Lademodell (60) elektrofahrzeugseitig oder ladestationsseitig generiert wird;
- Hochladen über ein Netzwerk oder direktes Übertragen der Messdaten (58) oder des Lademodells (60) auf die Servervorrichtung (18);
- Herunterladen der Messdaten (58) 2. und des Lademodells (60) mittels der Emulationsvorrichtung (32) über das Netzwerk oder direktes Empfangen von der Modellierungsvorrichtung (14) oder der Messvorrichtung (12);
- Emulieren der Aktion oder der Reaktion des Ladevorgangs durch die Emulationsvorrichtung (32) durch Abspielen der ausgewählten in Aktions- und Reaktionsdaten aufgeteilten Messdaten (58) und des entsprechend generierten Lademodells (60) auf der Emulationsvorrichtung (32).

18. Verfahren nach Anspruch 17, **dadurch gekennzeichnet, dass** die Messdaten (58) und / oder das Lademodell (60) auf der Emulationsvorrichtung (32) manuell, automatisiert oder halbautomatisiert emuliert werden.

19. Verfahren nach Anspruch 17 oder 18, **dadurch gekennzeichnet, dass** vor dem Hochladen der Messdaten (58) auf die Servervorrichtung (18) die Messdaten (58) mittels einer Aufteilungsvorrichtung (20), insbesondere einer Aufteilungseinrichtung (36) nach einer vordefinierten Verhaltensweise des Elektrofahrzeugs (50) und / oder der Ladestation (52) aufgeteilt, insbesondere nach Aktions- und Reaktionsdaten aufgeteilt werden.

20. Verfahren nach einem der Ansprüche 17 bis 19, **dadurch gekennzeichnet, dass** vor dem Hochladen der Messdaten (58) auf die Servervorrichtung (18) die Messdaten (58) mittels einer Analyseeinrichtung (66) analysiert und die elektrischen Verhaltensweisen, Protokollparameter und Kommunikationsinhalte des Ladevorgangs des Elektrofahrzeugs (50) und / oder der Ladestation (52) mittels einer Simulationseinrichtung (68) der Modellierungsvorrichtung (14) simuliert werden.

21. Verfahren nach einem der Ansprüche 17 bis 20, **dadurch gekennzeichnet, dass** ein Zugriff auf die Servervorrichtung (18) über eine Zugriffskontrolleinrichtung (48) gesteuert wird.

## Claims

1. Electromobility charge testing system (10) for generating and exchanging measurement data (58) or a charging model (60) of electric behaviors, in particular voltage and / or current behaviors, protocol parameters and communication contents of a charging operation of an electric vehicle (50) and / or charging station (52), wherein the charging operation consists of an action of the electric vehicle (50) and a reaction of the charging station (52), and for testing the communication capability and / or chargeability of the electric vehicle (50) and / or charging station (52) comprising at least one measuring device (12) for providing the measurement data (58) of the electrical behaviors, protocol parameters and / or communication contents of the charging operation of the electric vehicle (50) and / or charging station (52), wherein the electromobility charge testing system (10) further comprises:
- at least one modeling device (14) for creating a charging model (60) of the charging operation, configured to automatically generate the charging model (60) for action and reaction on the basis of the measurement data (58) logged by the measuring device (12), whereby charging models (60) are generatable,
- at least one server device (18) for storage and provision of an exchange possibility for the measurement data (58) or charging model (60), such that the measurement data (58) or the charging model (60) is uploadable directly or via a network to the server device (18) and / or downloadable from the server device (18), **characterized in that** the charging models (60) are generatable by the electric vehicle or the charging station; that the electromobility charge testing system (10) is configured to subdivide the measurement data (58) into action data loggable during the charging operation in accordance with the action of the electric vehicle (50) and reaction data of the charging station (52) adapting to the action, and that the the electromobility charge testing system (10) further comprises:
- at least one emulation device (32) for downloading the measurement data (58) and the charging model (60) from the measuring device (12) or from the modeling device (14) or from the server device (18) and for emulating the action of the charging operation of the electric vehicle (50) and the reaction of the charging operation of the charging station (52) by playing back the measurement data (58) subdivided into action data and reaction data and the correspondingly generated charging model (60).

2. Electromobility charge testing system (10) according to claim 1, **characterized in that** the measuring device (12) comprises an interface sub-device (22) for connection to an electric vehicle (50) and / or charging station (52), a recording sub-device (16) and a network connection sub-device (26), wherein the measurement data (58) is recordable via the interface sub-device (22) by means of the recording sub-device (16), and is uploadable by the network connection sub-device (26) to the server device (18) and / or transferable to the modeling device (14).

3. Electromobility charge testing system (10) according to claim 2, **characterized in that** the network connection sub-device (26) is designed as a cable-connected data interface, in particular as a CAN interface, Ethernet, LIN, RS232, GPIB, SPI, 12C, MOST-Bus, FlexRay, Profibus, CANopen, SERCOS, or as a wireless network connection sub-device, in particular a LAN, mobile radio, WLAN or NFC/RFID network connection sub-device, such that the measurement data (58) is transferrable via the network connection sub-device (26) within the electromobility charge testing system (10) and / or onto the server device (18) and / or to the modeling device (14).

4. Electromobility charge testing system (10) according to any of the preceding claims, **characterized in that** in the modeling device (14) at least one network connection apparatus (26), preferably a wireless network connection apparatus, in particular a radio, WLAN or NFC network connection apparatus, for reading out the measurement data (58) from the measuring device (12) and / or from the server device (18); at least one modeling apparatus (30) for modeling the measurement data (58) of the charging operation, in particular two modeling apparatuses (30) for modeling the measurement data of the electric vehicle (50) and / or charging station (52); at least one processing apparatus (28) for processing the measurement data (58) into a data format adapted to the charging model (60); and at least one network connection apparatus (26) for uploading the charging model (60) to the server device (18) and / or downloading measurement data (58) from the server device (18) and / or for transmission to the emulation device (32) are comprised.

5. Electromobility charge testing system (10) according to claim 4, **characterized in that** a subdividing device (20) is comprised which is configured to subdivide measurement data (58) according to a predefined behavior of the electric vehicle (50) and / or charging station (52), in particular into action data and reaction data.

6. Electromobility charge testing system (10) according to claim 5, **characterized in that** the subdividing device (20) comprises at least one network connection apparatus (26) for reading out and / or transferring or downloading and / or uploading of the measurement data (58) from the measuring device (12) and / or modeling device (14) and / or server device (18), and at least one subdividing apparatus (36) for performing a predefinable data subdivision.

7. Electromobility charge testing system (10) according to claim 5 or 6, **characterized in that** the subdividing apparatus (36) is comprised in the modeling device (14) in order to permit use of the action data and reaction data (AD, RD) in different ways.

8. Electromobility charge testing system (10) according to claim 4, **characterized in that** at least one analysis apparatus (66) and / or one simulation apparatus (68) are comprised in the modeling device (14), wherein the analysis and / or simulation apparatus (66, 68) are configured to analyze the measurement data (58) subdivided into action data and reaction data and to simulate the electrical behaviors, protocol parameters and communication contents of the charging operation of the electric vehicle (50) and / or charging station (52).

9. Electromobility charge testing system (10) according to any of the above claims, **characterized in that** the emulation device (32) comprises at least one network connection sub-device (26) for downloading the measurement data (58) and / or charging model (60) and at least one emulation sub-device (34), wherein the recorded or simulated electrical behaviors, protocol parameters and communication contents of the charging operation of the electric vehicle (50) and / or charging station (52) are imitable or emulatable by the emulation sub-device (34).

10. Electromobility charge testing system (10) according to claim 9, **characterized in that** the emulation sub-device (34) comprises a selection sub-device (38) configured to subdivide the measurement data (58) and / or the charging model (60) downloaded from the server device (18), in particular into action and reaction data, whereby prior to the emulation an adapted electrical behavior, protocol parameters and communication contents are providable manually, automatically or semiautomatically for a realistic simulation of the electric vehicle (50) and / or charging station (52).

11. Electromobility charge testing system (10) according to any of the previous claims, **characterized in that** the measuring device (12) and the modeling device (14) are structurally enclosed in a housing.

12. Electromobility charge testing system (10) according to any of the previous claims, **characterized in that** the modeling device (14) and the emulation device (32) are structurally enclosed in a housing.

13. Electromobility charge testing system (10) according to any of the previous claims, **characterized in that** the server device (18) is designed at least partially as a cloud-based internet server, wherein any access to the server device (18) is preferably controllable by an access check apparatus (48).

14. Electromobility charge testing system (10) according to any of the previous claims, **characterized in that** the modeling device (14) is arranged in the server device (18).

15. Electromobility charge testing system (10) according to any of the previous claims, **characterized in that** a subdividing device (20) is arranged in the server device (18) and is configured to subdivide the measurement data (58) according to a predefined behavior of the electric vehicle (50) and / or charging station (52), in particular into action data and reaction data.

16. Electromobility charge testing system (10) according to any of the previous claims, **characterized in that** the measurement data (58) and / or the charging model (60) comprises metadata (62) on the electric vehicle (50) and / or charging station (52) which is logged by the measuring device (12) during measurement between the charging station (52) and the electric vehicle (50), in particular equipment manufacturer, equipment type, date of manufacture, serial number, software version, recording date, equipment image, rating plate, equipment location, battery capacity and / or battery internal resistance, and information on the measuring device (12) such as equipment type, firmware version, equipment manufacturer, hardware version, and / or software scope.

17. Electromobility charge testing method for generating and exchanging measurement data (58) and / or a charging model (60) of electric behaviors, in particular voltage and / or current behaviors, protocol parameters and communication contents of a charging operation of an electric vehicle (50) and / or charging station (52), wherein the charging operation consists of an action of the electric vehicle (50) and a reaction of the charging station (52), and for testing the communication capability of the electric vehicle and / or charging station by an electromobility charge testing system (10) according to any of the previous claims, comprising the step:
- measuring the electrical behaviors, protocol parameters and communication contents of the charging operation of the electric vehicle (50) and / or charging station (52) by the measuring device (12),
**characterized in**
**that** the measurement data (58) is subdivided into action data logged during the charging operation in accordance with the action of the electric vehicle (50) and reaction data of the charging station (52) adapting to the action, and the electromobility charge testing method further comprises the steps:
- automatically generating a charging model (60) of the charging operation for the action data and reaction data by the modeling device (14), based on the logged measurement data (58), whereby the charging model (60) is generated by the electric vehicle or the charging station;
- uploading via a network or directly transferring the measurement data (58) or charging model (60) to the server device (18);
- downloading the measurement data (58) and charging model (60) by means of the emulation device (32) via the network or direct reception from the modeling device (14) or measuring device (12);
- emulating the action or reaction of the charging operation by the emulation device (32) by playing back the selected measurement data (58) subdivided into action data and reaction data and the correspondingly generated charging model (60) on the emulation device (32).

18. Method according to claim 17, **characterized in that** the measurement data (58) and / or the charging model (60) on the emulation device (32) are emulated manually, automatically or semiautomatically.

19. Method according to claim 17 or 18, **characterized in that** before the measurement data (58) is uploaded to the server device (18) it can be subdivided by means of a subdividing device (20), in particular a subdividing sub-device (36), according to a predefined behavior of the electric vehicle and (50) and / or charging station (52), in particular into action data and reaction data.

20. Method according to any of claims 17 to 19, **characterized in that** before the measurement data (58) is uploaded to the server device (18) it can be analyzed by means of an analysis apparatus (66) and the electrical behaviors, protocol parameters and communication contents of the charging operation of the electric vehicle (50) and / or charging station (52) can be simulated by means of a simulation apparatus (68) of the modeling device (14).

21. Method according to one of claims 17 to 20, **characterized in that** any access to the server device (18) can be controlled via an access check apparatus (48).

## Revendications

1. Système testeur de charge pour l'électromobilité (10) destiné à générer et échanger des données de mesure (58) ou un modèle de charge (60) de comportements électriques, notamment de comportements de tension et/ou d'intensité, paramètres de protocole et contenus de communication d'un processus de charge d'un véhicule électrique (50) et/ou d'une borne de recharge (52), sachant que le processus de charge se compose d'une action du véhicule électrique (50) et d'une réaction de la borne de recharge (52), ainsi que pour contrôler la capacité de communiquer et/ou la capacité de charger du véhicule électrique (50) et/ou de la borne de recharge (52) comprenant au moins un dispositif de mesure (12) pour fournir des données de mesure (58) des comportements électriques, paramètres de protocole et/ou contenus de communication du processus de charge du véhicule électrique (50) et/ou de la borne de recharge (52), sachant que le système testeur de charge pour l'électromobilité (10) comprend également :
- au moins un dispositif de modélisation (14) pour créer un modèle de charge (60) du processus de charge, configuré pour générer de manière automatisée le modèle de charge (60) pour l'action et la réaction, en se basant sur les données de mesure (58) acquises par le dispositif de mesure (12), ce qui permet de générer des modèles de charge (60),
- au moins un dispositif serveur (18) pour enregistrer et fournir un moyen d'échange des données de mesure (58) ou du modèle de charge (60) de sorte que les données de mesure (58) ou le modèle de charge (60) sont téléversables vers le dispositif serveur (18) directement ou via un réseau et/ou téléchargeables depuis le dispositif serveur (18), **caractérisé en ce que** les modèles de charge (60) sont générables du côté du véhicule électrique ou de la borne de recharge ; que le système testeur de charge pour l'électromobilité (10) est configuré pour répartir les données de mesure en données d'action, qui peuvent être acquises lors du processus de charge en fonction de l'action du véhicule électrique (50), et en données de réaction de la borne de recharge (52), s'adaptant à l'action, et que le système testeur de charge pour l'électromobilité (10) comprend également :
- au moins un dispositif d'émulation (32) pour télécharger les données de mesure et le modèle de charge (60) depuis le dispositif de mesure (12), ou le dispositif de modélisation (14) ou le dispositif serveur (18) et pour émuler l'action du processus de charge du véhicule électrique (50) et la réaction du processus de charge de la borne de recharge (52) en lisant les données de mesure (58) réparties en données d'action et de réaction et le modèle de charge (60) généré en conséquence.

2. Système testeur de charge pour l'électromobilité (10) selon la revendication 1, **caractérisé en ce que** le dispositif de mesure (12) comprend un équipement d'interface (22) pour le raccordement à un véhicule électrique (50) et/ou une borne de recharge (52), un dispositif d'enregistrement (16) et un équipement de connexion au réseau (26), sachant que les données de mesure (58) sont journalisables via l'équipement d'interface (22) au moyen du dispositif d'enregistrement (16), et téléversables sur le dispositif serveur (18) via l'équipement de connexion au réseau (26) et/ou transférables vers le dispositif de modélisation (14).

3. Système testeur de charge pour l'électromobilité (10) selon la revendication 2, **caractérisé en ce que** l'équipement de connexion au réseau (26) est conçu sous forme d'interface de données filaire, notamment d'interface CAN, Ethernet, LIN, RS232, GPIB, SPI, I2C, bus MOST, FlexRay, Profibus, CANopen, SERCOS, ou d'équipement de connexion au réseau sans fil, notamment d'équipement de connexion au réseau LAN, téléphonie mobile, WLAN ou NFC/RFID, de sorte que les données de mesure (58) peuvent être transmises via l'équipement de connexion au réseau (26) à l'intérieur du système testeur de charge pour l'électromobilité (10) et/ou au dispositif serveur (18) et/ou au dispositif de modélisation (14).

4. Système testeur de charge pour l'électromobilité (10) selon l'une des revendications précédentes, **caractérisé en ce que** sont compris, dans le dispositif de modélisation (14) au moins un équipement de connexion au réseau (26), de préférence un équipement de connexion au réseau sans fil, en particulier un équipement de connexion radio, WLAN ou NFC, pour lire les données de mesure (58) provenant du dispositif de mesure (12) et/ou du dispositif serveur (18), au moins un dispositif de modélisation (30) pour la modélisation des données de mesure (58) du processus de charge, notamment deux dispositifs de modélisation (30) pour la modélisation des données de mesure du véhicule électrique (50) et/ou de la borne de recharge (52), au moins un dispositif de préparation (28) pour convertir les données de mesure (58) dans un format de données adapté au modèle de charge (60) et au moins un équipement de connexion au réseau (26) pour téléverser le modèle de charge (60) vers le dispositif serveur (18) et/ou télécharger les données de mesure (58) depuis le dispositif serveur (18) et/ou pour la transmission vers le dispositif d'émulation (32).

5. Système testeur de charge pour l'électromobilité (10) selon la revendication 4, **caractérisé en ce qu'**est compris un dispositif de répartition (20) qui est configuré pour répartir des données de mesure (58) selon un comportement prédéfini du véhicule électrique (50) et/ou de la borne de recharge (52), notamment en données d'action et de réaction.

6. Système testeur de charge pour l'électromobilité (10) selon la revendication 5, **caractérisé en ce que** le dispositif de répartition (20) comprend au moins un équipement de connexion au réseau (26) pour lire et/ou remettre ou télécharger et/ou téléverser les données de mesure (58) provenant du dispositif de mesure (12) et/ou du dispositif de modélisation (14) et/ou du dispositif serveur (18), et au moins un dispositif de répartition (36) pour exécuter une répartition des données prédéfinissable.

7. Système testeur de charge pour l'électromobilité (10) selon la revendication 5 ou 6, **caractérisé en ce que** le dispositif de répartition (36) est compris dans le dispositif de modélisation (14) pour pouvoir exploiter différemment les données d'action et de réaction (AD, RD).

8. Système testeur de charge pour l'électromobilité (10) selon la revendication 4, **caractérisé en ce qu'**au moins un dispositif d'analyse (66) et/ou un dispositif de simulation (68) sont compris dans le dispositif de modélisation (14), sachant que le dispositif d'analyse et/ou de simulation (66, 68) est configuré pour analyser les données de mesure (58) réparties en données d'action et de réaction et simuler les comportements électriques, paramètres de protocole et contenus de communication du processus de charge du véhicule électrique (50) et/ou de la borne de recharge (52).

9. Système testeur de charge pour l'électromobilité (10) selon l'une des revendications précédentes, **caractérisé en ce que** le dispositif d'émulation (32) comprend au moins un équipement de connexion au réseau (26) pour télécharger les données de mesure (58) et/ou le modèle de charge (60) et au moins un dispositif d'émulation (34), sachant que les comportements électriques, paramètres de protocole et contenus de communication enregistrés/simulés du processus de charge du véhicule électrique (50) et/ou de la borne de recharge (52) peuvent être imités/émulés par le dispositif d'émulation (34).

10. Système testeur de charge pour l'électromobilité (10) selon la revendication 9, **caractérisé en ce que** le dispositif d'émulation (34) comprend un dispositif de sélection (38) qui est configuré pour répartir les données de mesure (58) téléchargées depuis le dispositif serveur (18) et/ou le modèle de charge (60), notamment en données d'action et de réaction, ce qui permet de fournir manuellement, automatiquement ou semi-automatiquement, avant l'émulation, un comportement électrique adapté, des paramètres de protocole et des contenus de communication pour une représentation proche de la réalité du véhicule électrique (50) et/ou de la borne de recharge (52).

11. Système testeur de charge pour l'électromobilité (10) selon l'une des revendications précédentes, **caractérisé en ce que** le dispositif de mesure (12) et le dispositif de modélisation (14) sont compris, au niveau de la construction, dans un boîtier.

12. Système testeur de charge pour l'électromobilité (10) selon l'une des revendications précédentes, **caractérisé en ce que** le dispositif de modélisation (14) et le dispositif d'émulation (32) sont compris, au niveau de la construction, dans un boîtier.

13. Système testeur de charge pour l'électromobilité (10) selon l'une des revendications précédentes, **caractérisé en ce que** le dispositif serveur (18) est conçu au moins partiellement comme serveur internet basé sur le cloud, sachant que de préférence, un accès au dispositif serveur (18) est contrôlable par un dispositif de contrôle d'accès (48)

14. Système testeur de charge pour l'électromobilité (10) selon l'une des revendications précédentes, **caractérisé en ce que** le dispositif de modélisation (14) est disposé dans le dispositif serveur (18).

15. Système testeur de charge pour l'électromobilité (10) selon l'une des revendications précédentes, **caractérisé en ce qu'**est disposé dans le dispositif serveur (18) un dispositif de répartition (20) qui est conçu pour répartir les données de mesure (58) selon un comportement prédéfini du véhicule électrique (50) et/ou de la borne de recharge (52), pour les répartir en particulier en données d'action et de réaction.

16. Système testeur de charge pour l'électromobilité (10) selon l'une des revendications précédentes, **caractérisé en ce que** les données de mesure (58) et/ou le modèle de charge (60) comprennent des métadonnées (62) sur le véhicule électrique (50) et/ou la borne de recharge (52), qui sont acquises lors de la mesure entre la borne de recharge (52) et le véhicule électrique (50) par le dispositif de mesure (12), telles que, notamment, fabricant de l'appareil, type d'appareil, date de fabrication, numéro de série, version du logiciel, date d'enregistrement, illustration de l'appareil, plaque signalétique, localisation de l'appareil, capacité de la batterie et/ou résistance interne de la batterie, ainsi que des informations sur le dispositif de mesure (12), telles que type d'appareil, version du micrologiciel, fabricant de l'appareil, version du matériel et/ou étendue du logiciel.

17. Système testeur de charge pour l'électromobilité destiné à générer et échanger des données de mesure (58) ou un modèle de charge (60) de comportements électriques, notamment de comportements de tension et/ou d'intensité, paramètres de protocole et contenus de communication d'un processus de charge d'un véhicule électrique (50) et/ou d'une borne de recharge (52), sachant que le processus de charge se compose d'une action du véhicule électrique (50) et d'une réaction de la borne de recharge (52), ainsi que pour contrôler la capacité de communiquer du véhicule électrique et/ou de la borne de recharge par un système testeur de charge pour l'électromobilité (10) selon l'une des revendications précédentes, comprenant l'étape suivante :
- mesure des comportements électriques, paramètres de protocole et contenus de communication du processus de charge du véhicule électrique (50) et/ou de la borne de recharge (52) par le dispositif de mesure (12),
**caractérisé en ce**
**que** les données de mesure (58) sont réparties en données d'action qui sont acquises en fonction de l'action du véhicule électrique (50) lors du processus de charge, et en données de réaction de la borne de recharge (52) s'adaptant à l'action, et que le système testeur de charge pour l'électromobilité comprend de plus les étapes suivantes :
- génération automatisée du modèle de charge (60) du processus de charge pour les données d'action et de réaction par le dispositif de modélisation (14), en se basant sur les données de mesure acquises (58), suite à quoi le modèle de charge (60) est généré côté véhicule électrique ou côté borne de station ;
- téléversement via un réseau ou transmission directe des données de mesure (58) ou du modèle de charge (60) vers le dispositif serveur (18) ;
- téléchargement des données de mesure (58) et du modèle de charge (60) au moyen du dispositif d'émulation (32) via le réseau ou réception directe depuis le disposition de modélisation (14) ou le dispositif de mesure (12) ;
- émulation de l'action ou de la réaction du processus de charge par le dispositif d'émulation (32) par le biais de la lecture des données de mesure (58) sélectionnées, réparties en données d'action et de réaction et du modèle de charge (60) généré en conséquence, sur le dispositif d'émulation (32).

18. Procédé selon la revendication 17, **caractérisé en ce que** les données de mesure (58) et/ou le modèle de charge (60) sont émulés manuellement, de manière automatisée ou semi-automatisée sur le dispositif d'émulation (32).

19. Procédé selon la revendication 17 ou 18, **caractérisé en ce qu'**avant le téléversement des données de mesure (58) vers le dispositif serveur (18), les données de mesure (58) sont réparties au moyen d'un dispositif de répartition (20), notamment d'un équipement de répartition (36) selon un comportement prédéfini du véhicule électrique (50) et/ou de la borne de recharge (52), notamment selon des données d'action et de réaction.

20. Procédé selon l'une des revendications 17 à 19, **caractérisé en ce qu'**avant le téléversement des données de mesure (58) vers le dispositif serveur (18), les données de mesure (58) sont analysées au moyen d'un dispositif d'analyse (66) et les comportements électriques, paramètres de protocole et contenus de communication du processus de charge du véhicule électrique (50) et/ou de la borne de recharge (52) sont simulés au moyen du dispositif de simulation (68) du dispositif de modélisation (14).

21. Procédé selon l'une des revendications 17 à 20, **caractérisé en ce qu'**un accès au dispositif serveur (18) est commandé via un dispositif de contrôle d'accès (48).
